# EUROPEAN PATENT APPLICATION

(11) **EP 4 804 785 A1**
(43) Date of publication of application: **09.09.2026**
(21) Application number: 26161578.5
(22) Date of filing: 02.03.2026
(51) Int. Cl.: H10W 90/10, G11C 5/02, G11C 11/54

(54) **SEMICONDUCTOR PACKAGE FOR SRAM AND NPU**

(30) Priority: 05.03.2025 KR 20250028222
(71) Applicant: Deepx Co., Ltd., Seongnam-si, Gyeonggi-do 13494 (KR)
(72) Inventor: YU, Cheong Sik, 06267 Seoul (KR)
(74) Representative: Viering, Jentschura & Partner mbB Patent- und Rechtsanwälte

(57) **Abstract**

Neural Processing Unit (NPU) semiconductor packages are provided. According to one embodiment, a semiconductor package (5000) comprises a substrate (5950), at least one NPU chip (100) mounted on the substrate (5950) and disposed in a first rotated orientation relative to a side or reference axis of the substrate (5950), and at least one static random-access memory (SRAM) chip (200-1, 200-2, 200-3, 200-4) mounted adjacent to the at least one NPU chip (100) on the substrate (5950) and disposed in a second rotated orientation, wherein the first orientation of the at least one NPU chip (100) and the second orientation of the at least one SRAM chip (200-1, 200-2, 200-3, 200-4) are configured in a rotated layout such that overall dimensions of the substrate (5950) conform to a predetermined form factor smaller than a form factor of a standard non-rotated layout.

## Description

### BACKGROUND OF THE DISCLOSURE

The present disclosure relates to semiconductor packages. Due to the rapid development of the electronics industry and the needs of users, electronic devices are becoming smaller and lighter. In response to the miniaturization and lightweight of electronic devices, the semiconductor packages used in them are also miniaturized and have become lightweight, and the semiconductor packages require high reliability along with high performance and high capacity.

Concerns about the sustainability of rapidly advancing AI are growing. Semiconductors, primarily GPUs and HBM memory, are limiting the continued advancement of AI by driving up the power usage and cost of AI data centers. For example, the power demand of global data centers is now greater than the power demand of a single developed country. According to current predictions, the growing demand for AI semiconductors will put the supply capacity of human civilization's social infrastructure, such as power plants and electricity supply chains, at risk.

In step with the recent spread of AI to all industries, the on-device AI, which provides AI services on the device itself, has emerged, thus creating a new market for AI semiconductors.

On-device AI services are being actively developed in areas such as automotive, robots, drones, extended reality (XR), energy, intelligent home appliances, wearable healthcare, digital manufacturing, distribution/logistics, CCTV, defense, and more.

Various inference services are being developed for on-device AI services, and various neural network models are being developed for academic, content, traffic control, legal, education, CCTV, communication base stations and the like.

By providing AI services on-device, AI services can be optimized for personalization. On the other hand, implementing the on-device AI services requires overcoming several challenges in environments different from data centers. First, it should be able to deliver ultra-lightweight, high-performance AI models that match the performance of hyperscale AI models.

### SUMMARY OF THE DISCLOSURE

Providing AI services on-device may be limited by the physical size of an AI semiconductor. On-devices can be wearable devices, smart devices, bipedal robots, quadrupedal robots, drones and the like, where the physical size of the AI semiconductor can be critical.

Providing AI services on-device may limit the power consumption of AI semiconductors. If the power consumption of the on-device is large, the operation time of battery-powered devices may be excessively short. Therefore, reducing the power consumption of on-device AI semiconductors can be very important.

To provide AI services on-device, it is necessary to overcome various technical challenges.

First, sufficient bandwidth between the processor and memory must be ensured. If the bandwidth between the processor and memory in an on-device system is not ensured, it may impact AI computation performance in various ways. However, the memory that may be used on-device may be limited. Consequently, server-class High Bandwidth Memory (HBM) may present challenges for on-device adoption due to its large size and high power consumption. Furthermore, when an on-device system is battery-powered, Dynamic Random Access Memory (DRAM) may have the disadvantage of reducing battery runtime.

Second, the physical distance between the processor and memory should be minimized. Increasing the physical distance between the on-device processor and memory can have several effects on power consumption.

For example, there is the issue of increased power consumption. Longer physical distances increase power consumption by increasing the resistance and capacitance of the wiring between the processor and memory. This increased resistance requires more energy to carry signals over longer distances, resulting in higher power dissipation in the form of heat.

For example, signal integrity issues may arise. Signal integrity issues such as signal degradation and increased susceptibility to interference, can occur as the distance increases. To maintain signal integrity, the system may need to increase voltage levels or use more sophisticated signaling techniques, both of which can increase power consumption.

For example, the need for signal amplification may arise. To maintain signal integrity over long distances, signal amplification mechanisms such as repeaters or amplifiers may be required. These additional elements consume power and thus further contribute to the overall system power consumption.

For example, there is the issue of increased latency. The greater distance between the processor and memory can increase latency because it takes longer for signals to travel between the two elements. The increased latency can cause the system to operate inefficiently, potentially increasing power consumption as the processor may wait longer for data.

For example, the problem of increasing dynamic power may arise. The dynamic power consumption associated with the switching transistors can increase with increasing distance. This is because the parasitic capacity increases with longer wirings, requiring more energy to charge and discharge during each switching cycle.

Accordingly, the present disclosure has conducted various studies on semiconductor packaging that can be applied to on-devices.

Accordingly, it is an object of the present disclosure to provide semiconductor packages for neural processing units (NPUs) and NPU dedicated static random-access memory (SRAM).

To achieve the aforementioned objectives, the present disclosure provides a semiconductor package according to claim 1. Further embodiments are described in the dependent claims. According to one embodiment of the present disclosure, an NPU semiconductor package is provided. According to one embodiment, the NPU semiconductor package comprises a semiconductor package substrate, an NPU chip mounted on the semiconductor package substrate and disposed in a first rotated orientation (e.g., a first angle) with respect to one side of the substrate based on a planar reference, and one or more SRAM chips mounted on the semiconductor package substrate adjacent to the NPU chip and disposed in a second rotated orientation (e.g., a second angle) with respect to the one side of the substrate based on the planar reference. The first angle and the second angle may be determined such that the size of the semiconductor package substrate is smaller than that of a predetermined form factor.

According to another embodiment of the present disclosure, an NPU semiconductor package is provided. The NPU semiconductor package comprises a substrate, an NPU mounted on the substrate, rotated at a first angle with respect to one side of the substrate based on a planar reference, and one or more SRAM units mounted on the substrate adjacent to the NPU, rotated at a second angle with respect to the one side of the substrate based on the planar reference. The first angle and the second angle are adjusted such that the overall size of the substrate remains smaller than a designated form factor size.

According to a further embodiment of the present disclosure, an AI processor package is provided. The AI processor package comprises an AI processor configured to perform AI-specific operations, and one or more SRAM units electrically connected to the AI processor. The AI processor and the one or more SRAM units are arranged in a rotated multi-chip substrate layout, thereby forming a rotated multi-chip substrate package.

To achieve the foregoing objectives, another embodiment of the present disclosure provides an NPU semiconductor package. The NPU semiconductor package comprises a semiconductor package substrate having solder bumps formed on a lower surface, an NPU mounted diagonally on the semiconductor package substrate, and a plurality of SRAM units mounted on the semiconductor package substrate in a diagonal direction to surround the NPU.

The present disclosure relates generally to semiconductor packages, and more particularly, to semiconductor packages for artificial intelligence (AI) processing systems.

Advances in AI and Machine Learning (ML), including the development of Large Language Models (LLMs), create a demand for processing systems capable of high computational performance and requiring substantial memory capacity and bandwidth. Integrating memory that satisfies these requirements into increasingly compact semiconductor package form factors presents significant challenges.

One aspect of the present disclosure provides a semiconductor package configured to address these challenges. The package may comprise an NPU (Neural Processing Unit) and a plurality of SRAM (Static Random Access Memory) memories. SRAM is utilized to provide the high speed and wide bandwidth necessary for the NPU's demanding AI tasks, despite SRAM's characteristic lower integration density compared to other memory types. The NPU and the SRAM are manufactured using different semiconductor process technologies, where the respective process nodes are selected to optimize the performance, cost, and area characteristics for each chip. Furthermore, the semiconductor package may incorporate novel packaging configurations and optimized chip layouts that facilitate the integration of the NPU and the required SRAM capacity, enabling the overall package to fit within constrained dimensions.

This approach offers several advantages. The present disclosure provides a high-performance AI package capable of meeting the substantial memory capacity and bandwidth needs driven by applications such as LLMs. By employing optimized packaging configurations, the semiconductor package addresses the size challenge posed by SRAM's density and the need for multiple SRAM chips, thereby enabling integration into small form factors where conventional high-bandwidth memory solutions like DRAM or HBM may be impractical due to size or power constraints. The use of different process technologies for the NPU and SRAM allows for PPA (Performance, Power, and Area) optimization tailored to the specific requirements of each chip. Ultimately, the disclosed semiconductor package leverages the speed and capacity advantages of SRAM in a compact design, providing a robust solution for on-device AI processing.

According to one example of the present disclosure, an NPU semiconductor package with dedicated SRAM can be made compact.

According to one example of the present disclosure, high memory bandwidth can be reliably guaranteed to the NPU semiconductor through dedicated SRAM provided inside the package.

According to one example of the present disclosure, the parameters of a large neural network model can be reliably supplied to the NPU semiconductor via dedicated SRAM in an on-device environment.

According to one example of the present disclosure, NPU semiconductor packages with dedicated SRAM can be made compact to facilitate the commercialization of edge devices dedicated to AI inference.

### BRIEF DESCRIPTION OF THE DRAWINGS

FIG. 1 is a schematic diagram illustrating an example neural network model.
FIG. 2A is a schematic diagram illustrating the basic structure of a convolutional neural network (CNN).
FIG. 2B is a schematic diagram illustrating the operation of the convolutional neural network.
FIG. 3 is a schematic diagram illustrating a neural processing unit according to one example of the present disclosure.
FIG. 4A is a schematic diagram illustrating a processing element that may be applied according to one example of the present disclosure.
FIG. 4B is a schematic diagram illustrating a special function unit (SFU) that may be applied according to one example of the present disclosure.
FIG. 5 is a schematic diagram illustrating a variation of the neural processing unit shown in FIG. 3.
FIG. 6 is a block diagram illustrating a system according to one example.
FIGS. 7A and 7B are cross-sectional views illustrating before and after packaging of a fan-in semiconductor package.
FIG. 8 is a cross-sectional view illustrating a packaging process of a fan-in semiconductor package.
FIGS. 9A and 9B are cross-sectional views illustrating a fan-in semiconductor package mounted on an interposer substrate and mounted on a main board of an electronic device (FIG. 9A), and a fan-in semiconductor package embedded within an interposer substrate and mounted on a main board of an electronic device (FIG. 9B).
FIG. 10 is a cross-sectional view illustrating a fan-out semiconductor package.
FIG. 11 is a cross-sectional view illustrating a fan-out semiconductor package mounted on a main board of an electronic device.
FIG. 12 is a cross-sectional view illustrating a package-on-package according to a first example.
FIGS. 13A through 13D are cross-sectional views illustrating a method of manufacturing the package-on-package (PoP) shown in FIG. 12.
FIG. 14 is a cross-sectional view illustrating a package-on-package according to a second example.
FIGS. 15A through 15E illustrate a method of manufacturing the package-on-package (PoP) shown in FIG. 14.
FIG. 16 is a cross-sectional view illustrating a package-on-package according to a third example.
FIG. 17 is a cross-sectional view illustrating a package-on-package according to a fourth example.
FIG. 18 is a cross-sectional view illustrating a package according to a fifth example.
FIG. 19 is a cross-sectional view illustrating a package-on-package according to the sixth example.
FIG. 20 is a perspective view illustrating a semiconductor package according to a 2.5D package method.
FIG. 21 is a cross-sectional view of the semiconductor package shown in FIG. 20.
FIG. 22 is a top view illustrating the top surface of the interposer shown in FIG. 20.
FIG. 23 is a bottom view illustrating first and second base dies of the first and second memory stacks shown in FIG. 20.
FIG. 24 is a top view illustrating first and second base dies of the first and second memory stacks shown in FIG. 20.
FIG. 25 illustrates an example of a form factor with an M.2 slot.
FIG. 26 is a diagram illustrating a package according to the first embodiment of the present disclosure.
FIG. 27 is a diagram illustrating a package according to the second embodiment of the present disclosure.
FIG. 28 is a cross-sectional view illustrating the package shown in FIG. 26 or FIG. 27 according to lines A-A'.

### DETAILED DESCRIPTION OF THE EMBODIMENT

The specific structural or step-by-step descriptions of the examples of the present disclosure are intended only to illustrate examples according to the concepts of the present disclosure. Accordingly, examples according to the concepts of the present disclosure may be practiced in various forms. Examples according to the concepts of the present disclosure may be practiced in various forms. The present disclosure should not be construed as limiting to the examples of the present disclosure.

Various modifications can be made to the examples according to the concepts of the present disclosure and can take many forms. Accordingly, certain examples will be illustrated in the drawings and the present disclosure or application will be described in detail. However, this is not intended to limit examples according to the concepts of the present disclosure to any particular form of disclosure. The disclosure according to the concepts of the present disclosure should be understood to include all modifications, equivalents or substitutions that fall within the scope of the ideas and techniques of the present disclosure.

Terms such as first and/or second may be used to describe various elements, but the elements should not be limited by the terms. The terms may be used only for the purpose of distinguishing one element from another. A first element may be named as a second component, and similarly, a second element may be named as a first component, without departing from the scope of the rights according to the concepts of the present disclosure.

When an element is referred to as being "connected to" or "in contact with" another element, it may be directly connected or contacted to other element. However, it should be understood that other elements may exist in the middle of the plurality of elements. On the other hand, when an element is referred to as being "directly connected to" or "directly in contact with" another element, it should be understood that there are no other elements in between. Other expressions that describe relationships between elements, such as "between" and "directly between" or "adjacent to" and "directly adjacent to" should be interpreted similarly.

The terms used in the present disclosure are intended to describe specific examples only and are not intended to limit the present disclosure. Expressions in the singular include the plural unless the context clearly indicates otherwise. In the present disclosure, the terms "include" or "has" and the like are intended to designate the presence of the described features, numbers, steps, operations, elements, parts, or combinations thereof, and should be understood as not precluding the possibility of the presence or addition of one or more other features, numbers, steps, operations, elements, parts, or combinations thereof.

Unless otherwise defined, all terms used herein, including technical or scientific terms, shall have the same meaning as commonly understood by one of ordinary skill in the art to which the present disclosure belongs. Such terms, as defined in commonly used dictionaries, shall be construed to have a meaning consistent with their meaning in the context of the related art. Terms such as defined in commonly used dictionaries are not to be construed in an idealized or overly formal sense unless expressly defined in the present disclosure.

In describing the examples, description is omitted of technical details that are familiar to those skilled in the art to which the present disclosure belongs and that are not directly related to the present disclosure. This is done to make the present disclosure clearer without obscuring the essence of the disclosure by omitting unnecessary explanations.

### <Definitions of terms>

To facilitate understanding of the disclosures presented herein, the following is a brief summary of terms used in the present disclosure.

NPU: An abbreviation for neural processing unit, which can refer to a processor specialized for the computation of neural network models, separate from the central processing unit (CPU).

NN: An abbreviation for neural network, which can refer to a network of connected in a layer structure, mimicking the way neurons in the human brain are connected through synapses, to mimic human intelligence.

DNN: An abbreviation for deep neural network, which can increase the number of hidden layers of a neural network to achieve higher artificial intelligence.

CNN: An abbreviation for convolutional neural network, a neural network that performs functions similar to those of the visual cortex of the human brain. Convolutional neural networks are known to be suitable for image processing, and they are known to be easy to extract features from input data and identify patterns in the features.

Dedicated memory: Dedicated memory provided for data processed by the NPU, which can be configured to store the parameters of the neural network model and provide the NPU with the data needed to process the neural network model in real time. The dedicated memory is packaged with the NPU and can reduce the length of the data transfer path, thereby improving communication quality (e.g., signal-to-noise ratio).

Hereinafter, the present disclosure will be described in detail by describing preferred examples of the present disclosure with reference to the accompanying drawings. Hereinafter, examples of the present disclosure will be described in detail with reference to the accompanying drawings.

### <Artificial Intelligence>

Humans have the intelligence to recognize, classify, infer, predict, control/decision making and the like. Artificial intelligence (AI) refers to the artificial imitation of human intelligence.

The human brain is made up of tons of nerve cells called neurons. Each neuron is connected to hundreds to thousands of other neurons through connections called synapses. To mimic human intelligence, the operation of biological neurons and the connections between neurons are modeled in a neural network model. In other words, a neural network is a system of nodes connected in a layer structure that mimics neurons.

These neural network models are categorized according to the number of layers into 'single-layer neural networks' and 'multi-layer neural networks'. A typical multilayer neural network consists of an input layer, a hidden layer, and an output layer. (1) The input layer is a layer that receives external data, and the number of neurons in the input layer is the same as the number of input variables. (2) The hidden layer is located between the input layer and the output layer, and receives signals from the input layer, extracts characteristics, and passes them to the output layer. (3) The output layer receives signals from the hidden layer and outputs them to the outside. The input signals between neurons are multiplied by their respective connection strengths, which have a value between 0 and 1, and then summed up. If this sum is greater than the threshold of the neuron, the neuron is activated and the activation function is implemented as an output value.

On the other hand, in order to realize higher artificial intelligence, the number of hidden layers in a neural network is increased, which is called a deep neural network (DNN).

DNNs are being developed in a variety of structures. For example, convolutional neural network (CNN), which is an example of DNN, is known to be easy to extract features of input values (video or image) and identify patterns in the extracted output values. A CNN may consist of convolutional operations, activation function operations, pooling operations and the like. processed in a specific order.

For example, in each layer of the DNN, the parameters (e.g., input values, output values, weights or kernels and the like.) may be a matrix comprising a plurality of channels. The parameters may be processed in a neural processing unit (NPU) by convolutional or matrix multiplication. At each layer, an output value is generated after the operation is processed.

For example, the transformer model is a DNN based on attention techniques. The transformer utilizes many matrix multiplication operations. A transformer can take an input value and parameters such as query (Q), key (K), and value (V) to obtain an output value, that is the attention value (Q, K, V). Based on the output value (i.e., the attitude (Q, K, V)), the transformer can process various inference operations. Transformers tend to have better inference performance than CNNs.

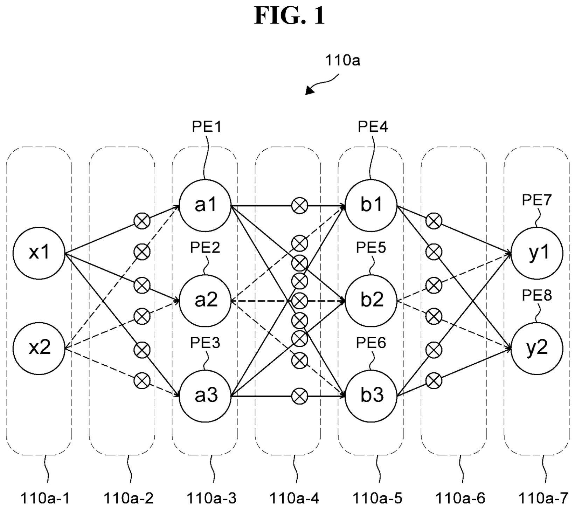

FIG. 1 is a schematic diagram illustrating an example neural network model.

The following describes operations of an example neural network model 110a that may be operated on the neural processing unit 100.

The example neural network model 110a of FIG. 1 may be a neural network trained to perform various inference functions, such as object detection, speech recognition and the like.

The neural network model 110a may be a deep neural network (DNN).

However, the neural network model 110a according to the examples of the present disclosure is not limited to a deep neural network.

For example, the neural network model 110a may include Chat-GPT, LLaMA, Stable Diffusion, LLM, Generative Adversarial Networks (GAN), Florence, DaViT, MobileViT, Swin-Transformer, Transformer, YOLO, CNN, PIDNet, BiseNet, RCNN, VGG, VGG16, DenseNet, SegNet, DeconvNet, DeepLAB V3+, U-net, SqueezeNet, Alexnet, ResNet18, MobileNet-v2, GoogLeNet, Resnet-v2, Resnet50, Resnet101, Inception-v3, and the like. However, the present disclosure is not limited to the above-described models. Furthermore, the neural network model 110a may be multi-modal or an ensemble model based on at least two different models.

The inference process performed by the exemplary neural network model 110a will now be described.

The neural network model 110a is an example deep neural network model including an input layer 110a-1, a first connection network 110a-2, a first hidden layer 110a-3, a second connection network 110a-4, a second hidden layer 110a-5, a third connection network 110a- 6, and an output layer 110a-7. However, the present disclosure is not limited to the neural network model illustrated in FIG. 1. The first hidden layer 110a-3 and the second hidden layer 110a-5 may also be referred to as a plurality of hidden layers.

The input layer 110a-1 may include, for example, x1 and x2 input nodes, i.e., the input layer 110a-1 may include information about two input values.

The first connection network 110a-2 may, for example, include information about six weight values for connecting each node of the input layer 110a-1 to each node of the first hidden layer 110a-3. Each weight value is multiplied with the input node value, and an accumulated value of the multiplied values is stored in the first hidden layer 110a-3. The weight values and the input node values may be referred to as parameters of the neural network model.

The first hidden layer 110a-3 may include, for example, nodes a1, a2, and a3, i.e., the first hidden layer 110a-3 may include information about three node values.

The first processing element PE1 of FIG. 1 may process operations of the a1 node.

The second processing element PE2 of FIG. 1 may process operations of the a2 node.

The third processing element PE3 of FIG. 1 may process the operations of the a3 nodes. The second connection network 110a-4 may include, for example, information about nine weight values for connecting each node of the first hidden layer 110a-3 to each node of the second hidden layer 110a-5. The weight values of the second connection network 110a-4 are each multiplied with the node values input from the first hidden layer 110a-3, and the accumulated values of the multiplied values are stored in the second hidden layer 110a-5.

The second hidden layers 110a-5 may include, for example, nodes b1, b2, and b3, i.e., the second hidden layers 110a-5 may include information about values of three nodes.

The fourth processing element PE4 of FIG. 1 can process the operations of the b1 node.

The fifth processing element PE5 in FIG. 1 can handle operations of the b2 node.

The sixth processing element PE6 of FIG. 1 can handle the operations of the b3 node.

The third connection network 110a-6 may include, for example, information about six weight values that associate each node of the second covert layer 110a-5 with each node of the output layer 110a-7. The weight values of the third connection network 110a-6 are each multiplied with the node values input from the second covert layer 110a-5, and the accumulated values of the multiplied values are stored in the output layer 110a-7.

The output layers 110a-7 may include, for example, the nodes Y1, and Y2, i.e., the output layers 110a-7 may include information about the values of two nodes.

The seventh processing element PE7 of FIG. 1 may process operations of the y1 node.

The eighth processing element PE8 of FIG. 1 may process operations of the y2 node.

Each node may correspond to a feature value, and a feature value may correspond to a feature map.

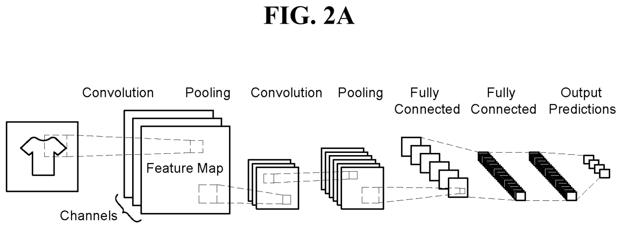

FIG. 2A is a schematic diagram illustrating the basic structure of a convolutional neural network (CNN).

Referring to FIG. 2A, the input image may be represented as a two-dimensional matrix comprising rows of a particular size and columns of a particular size. The input image may have a plurality of channels, where the channels may represent a number of color components of the input data image.

The process of convolution means iterating over the input image at specified intervals, performing kernel and convolution operations.

A convolutional neural network can have a structure that passes the output value of the current layer (convolution or matrix multiplication) to the input value of the next layer.

For example, a convolution is defined by two main parameters: an input feature map and a kernel. The parameters of a neural network model can include input feature map, output feature map, activation map, weights, kernel, and attentions (Q, K, V).

A convolution slides a kernel window over the input feature map. The size of the step by which the kernel slides over the input feature map is called the stride.

After convolution, pooling may be applied. In addition, a fully-connected (FC) layer may be placed at the end of the convolutional neural network.

However, the neural network models of the present disclosure are not limited to CNNs.

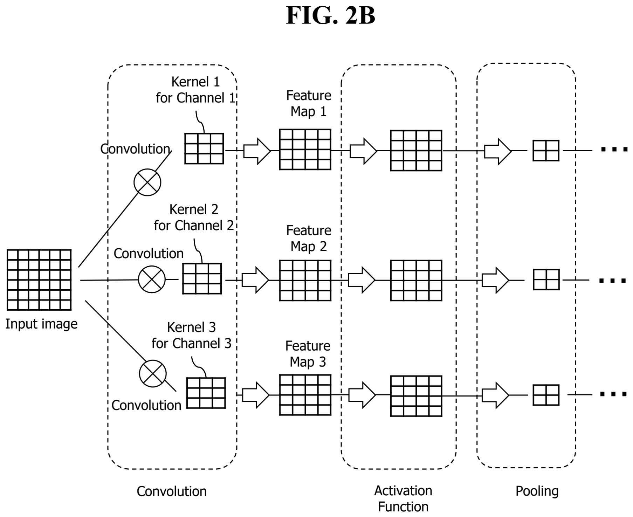

FIG. 2B is a schematic diagram illustrating the operation of the convolutional neural network.

Referring now to FIG. 2B, it is shown that the input image is exemplarily a two-dimensional matrix having a size of 6 x 6. Further, it is shown in FIG. 2B that three nodes are exemplarily used, namely channel 1, channel 2, and channel 3.

First, the convolution operation is explained.

The input image (exemplarily represented in FIG. 2B as being 6 x 6 in size) is convolved with a kernel 1 (exemplarily represented in FIG. 2B as being 3 x 3 in size) for channel 1 at a first node, resulting in a feature map 1 (exemplarily represented in FIG. 2B as being 4 x 4 in size). Further, the input image (exemplarily represented in FIG. 2B as being 6 x 6 in size) is convolved with a kernel 2 (exemplarily represented in FIG. 2B as being 3 x 3 in size) for channel 2 at a second node, and feature map 2 (exemplarily represented in FIG. 2B as being 4 x 4 in size) is output as a result. Further, the input image is convolved with a kernel 3 (exemplarily shown in FIG. 2B as being 3 x 3 in size) for channel 3 at a third node, and a feature map 3 (exemplarily shown in FIG. 2B as being 4 x 4 in size) is output as a result.

To process each convolution, the processing elements PE1 to PE12 of the neural processing unit 100 are configured to perform MAC operations.

Next, the operation of the activation function is explained.

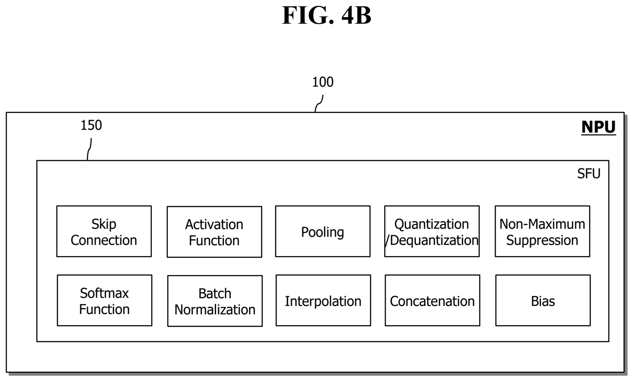

An activation function may be applied to feature map 1, feature map 2, and feature map 3 (each of which is shown in FIG. 4B as having an exemplary size of 4 x 4) that are output from the convolutional operation. The output after the activation function is applied may be of size, for example, 4 x 4.

Next, the pooling operation is explained.

The feature map 1, feature map 2, and feature map 3 (each of which is shown in FIG. 2B as having a size of 4 x 4 as an example) output from the above activation function are input to three nodes. Taking the feature maps output from the activation function as inputs, pooling can be performed. This pooling can be done to reduce the size or to emphasize certain values in the matrix. There are three types of pooling methods: max pooling, average pooling, and min pooling. Max pooling is used to collect the maximum number of values within a certain region of the matrix, while average pooling can be used to average the values within a certain region.

In the example of FIG. 2B, a feature map of size 4 x 4 is shown to be reduced to size 2 x 2 by pooling.

Specifically, the first node takes as input the feature map 1 for channel 1, performs the pooling, and outputs, for example, a 2 x 2 matrix. The second node takes as input the feature map 2 for channel 2, performs the pooling and outputs, for example, a 2 x 2 matrix. The third node takes as input the feature map 3 for channel 3, performs pooling, and outputs, for example, a 2 x 2 matrix.

The convolution, activation function, and pooling described above can be repeated and finally output as a fully connected layer. This output can then be fed back into a neural network for image recognition. However, the present disclosure is not limited to the size of the feature map or kernel.

Among the various deep neural network (DNN) methods described so far, CNNs are the most popular in the field of computer vision. In particular, CNNs have shown remarkable performance in various research areas, performing tasks as diverse as image classification and object detection.

However, the neural network model of the present disclosure is not limited to a CNN, and various neural network models can be processed by the NPU.

### <Hardware resources required for NN computation>

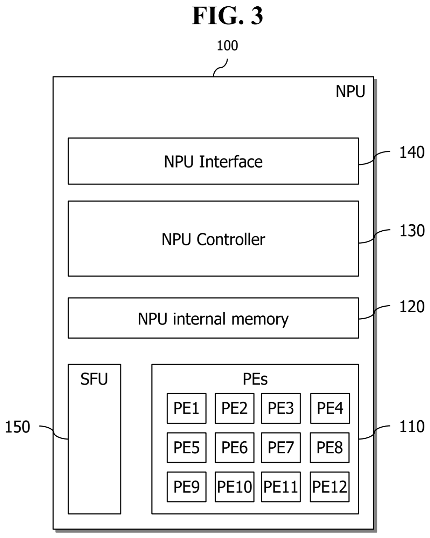

FIG. 3 is a schematic diagram illustrating a neural processing unit according to one example of the present disclosure.

A neural processing unit (NPU) 100, shown in FIG. 3, is a processor specialized to perform operations for a neural network.

A neural network is a collection of artificial neurons that receive multiple inputs or stimuli, multiply them by their respective weights, add them together, and then transform and transmit the deviations through an activation function. The trained neural network can be used to output inference results from input data.

The neural processing unit 100 may be a semiconductor chip implemented as an electrical/electronic circuit. By electrical/electronic circuitry, it may be meant to include a number of electronic elements (e.g., transistors, capacitors).

In the case of a neural network model based on a transformer and/or a CNN, the neural processing unit 100 may select and process matrix multiplication operations, convolutional operations, and the like according to the architecture of the neural network.

For example, in each layer of a convolutional neural network (CNN), an input feature map corresponding to the input data and a kernel corresponding to the weights may be a tensor or matrix comprising a plurality of channels. Convolution of the input feature map and the kernel is performed, and a convolution and pooled output feature map is generated from each channel. An activation function is applied to the output feature map to generate the activation map of the corresponding channel. Pooling may then be applied to the activation maps. As used herein, the activation map may be collectively referred to as the output feature map. For ease of description, the activation map will be referred to as the output feature map.

However, the examples of the present disclosure are not limited thereto, and the output feature map may be subjected to matrix multiplication operations, convolutional operations, or the like.

Furthermore, an output feature map according to the examples of the present disclosure should be interpreted in a comprehensive sense. For example, the output feature map may be the result of a matrix multiplication operation or a convolution operation. Accordingly, the plurality of processing elements 110 may be modified to further include processing circuit units for additional algorithms, i.e., some circuit units of the SFU 150, which will be described later, may be configured to be included in the plurality of processing elements 110.

The neural processing unit 100 may be configured to include a plurality of processing elements 110 for processing convolutional and matrix multiplication required for the neural network operations.

The neural processing unit 100 may be configured to include respective calculation circuits optimized for matrix multiplication operations, convolution operations, activation function operations, pooling operations, stride operations, batch-normalization operations, skip connection operations, splicing operations, quantization operations, inverse quantization operations, softmax function operations, clipping operations, and padding operations required for the neural network operations.

For example, the neural processing unit 100 may be configured to include an SFU 150 for processing at least one of the algorithms: an activation function operation, a pooling operation, a stride operation, a batch-normalization operation, a skip connection operation, a splicing operation, a quantization operation, a clipping operation, and a padding operation.

Specifically, the neural processing unit 100 may include a plurality of processing elements (PEs) 110, SFUs 150, NPU internal memory 120, NPU controller 130, and NPU interface 140. Each of the plurality of processing elements 110, SFU 150, NPU internal memory 120, NPU controller 130, and NPU interface 140 may be a semiconductor circuit with numerous transistors connected thereto. Accordingly, some of these may be difficult to identify and distinguish with the naked eye, and may be identified only by operation.

For example, a particular circuitry may operate as the plurality of processing elements 110, or it may operate as the NPU controller 130. The NPU controller 130 may be configured to perform functions of a controller configured to control neural network inference operations of the neural processing unit 100.

The neural processing unit 100 may include an NPU internal memory 120 configured to store parameters of a neural network model that may be inferred from the plurality of processing elements 110 and the SFU 150, and an NPU controller 130 configured to control a schedule of operations of the plurality of processing elements 110, the SFU 150, and the NPU internal memory 120.

The neural processing unit 100 may be configured to process the feature map in response to an encoding and decoding method using scalable video coding (SVC) or scalable feature-map coding (SFC). The above methods are techniques for variably varying the amount of data transmission according to the effective bandwidth and signal to noise ratio (SNR) of the communication channel or communication bus. In other words, the neural processing unit 100 may be configured to further include an encoder and a decoder.

The plurality of processing elements 110 may perform some of the operations for the neural network.

The SFU 150 may perform other portions of the operations for the neural network.

The neural processing unit 100 may be configured to hardware accelerate the computation of the neural network model using a plurality of processing elements 110 and SFUs 150.

The NPU interface 140 may communicate with various elements associated with the neural processing unit 100 via the system bus, such as memory. Here, the memory may be a dedicated memory for the NPU. Here, the dedicated memory may be memory circuitry included in the same package as the NPU.

The NPU controller 130 may be configured to control the order of operations of the plurality of processing elements 110, operations of the SFU 150, and reads and writes to the NPU internal memory 120 for inference operations of the neural processing unit 100. For example, the NPU controller 130 may be configured to schedule neural network operations or otherwise control each circuit unit of the neural processing unit 100 in a scheduled order.

The NPU controller 130 may be configured to control the plurality of processing elements 110, the SFU 150, and the NPU internal memory 120 based on information about data locality or structure of the neural network model.

The NPU controller 130 may analyze the structure of the neural network model to be operated on the plurality of processing elements 110 and the SFU 150, or may be provided with information that has already been analyzed. The analyzed information may be information generated by a compiler. For example, the data of the neural network that the neural network model may include may include at least some of the following: node data of each layer (i.e., feature map), batch data of the layers, locality information or information about the structure, and weight data (i.e., weight kernel) of each of the connections connecting the nodes of each layer. The data of the neural network may be stored in memory provided within the NPU controller 130 or in the NPU internal memory 120. However, without limitation, the data of the neural network may be stored in a separate cache memory or register file provided in the NPU or a system on chip (SoC) comprising the NPU.

The NPU controller 130 may schedule a sequence of computations of the neural network model to be performed by the neural processing unit 100 based on information about the data locality or structure of the neural network model.

The NPU controller 130 may be provided with scheduling information of a sequence of operations of the neural network model to be performed by the neural processing unit 100 based on information about data locality or structure of the compiled neural network model. For example, the scheduling information may be information generated by a compiler. The scheduling information generated by the compiler may be referred to as machine code, binary code, or the like.

In other words, the scheduling information utilized by the NPU controller 130 may be information generated by the compiler based on the data locality information or structure of the neural network model.

In other words, the compiler can efficiently schedule NPUs according to how well it understands and reconstructs neural network data locality, which is a unique characteristic of neural network models.

As described further below, the compiler can efficiently schedule the NPU according to how well it understands the hardware architecture and performance of the neural processing unit 100.

In addition, when the neural network model is compiled by the compiler to be executed on the neural processing unit 100, the neural network data locality may be reconfigured. The neural network data locality may be reconstructed according to the algorithms applied to the neural network model and the operation characteristics of the processor.

In addition, the neural network data locality may be reconstructed according to how the neural processing unit 100 processes the corresponding neural network model, e.g., feature map tiling, stationary of processing elements.

In addition, the neural network data locality may be reconfigured according to the number of processing elements of the neural processing unit 100, the capacity of the internal memory.

In addition, the neural network data locality may be reconfigured according to the bandwidth of the memory communicating with the neural processing unit 100.

This is because, even if the same neural network model is computationally processed by each of the factors described above, the neural processing unit 100 may determine differently the order of the data required at each moment of the clock.

The compiler may determine data locality based on the order of operations of the layers, unit convolutions, and/or matrix multiplications of the neural network model, and generate compiled machine code.

The compiler can be a separate piece of software that operates outside the NPU or an embedded compiler that operates inside the NPU.

The NPU controller 130 may be configured to utilize scheduling information contained in the machine code.

Based on the scheduling information, the NPU controller 130 may obtain a memory address value where the feature maps and weight data of the layers of the neural network model are stored. Here, the address value can include the address value of the NPU internal memory and/or the address value of the dedicated memory.

For example, the NPU controller 130 may obtain a memory address value where the feature maps and weight data of the layers of the neural network model stored in the memory (e.g., the NPU internal memory or the dedicated memory) are stored. Thus, the NPU controller 130 may fetch the activation parameters and weight parameters of the layers of the neural network model to be driven from the dedicated memory and store them in the NPU internal memory 120.

Each layer's activation parameter can have a corresponding respective memory address value.

Each weight parameter may have a corresponding respective memory address value.

The NPU controller 130 may be provided with scheduling information about the order of operations of the plurality of processing elements 110 based on information about the data locality information or structure of the neural network model, such as batch data of layers of the neural network model, locality information, or information about the structure of the neural network model. The scheduling order may be determined at a compilation stage or may be determined in real time.

Since the NPU controller 130 operates based on scheduling information based on data locality information or information about the structure of the neural network model, it may operate differently from the scheduling concept of a typical CPU. The scheduling of a general CPU operates to achieve the best possible efficiency, considering fairness, efficiency, stability, response time and the like.

Traditional CPUs use an algorithm that schedules tasks by considering data such as the priority of each processing and the processing time of the operation.

In contrast, the NPU controller 130 may control the neural processing units 100 in a processing order of the neural processing units 100 determined based on information about data locality or structure of the neural network model.

Further, the NPU controller 130 may drive the NPU 100 in a processing order determined based on the information about the data locality or structure of the neural network model and/or the information about the data locality or structure of the neural processing unit to be used.

However, the present disclosure is not limited to information about data locality or structure of the neural processing unit 100.

The NPU controller 130 may be configured to store information about data locality or structure of the neural network.

In other words, the NPU controller 130 can determine the order of processing by utilizing at least information about the data locality or structure of the neural network model.

Further, the NPU controller 130 may determine a processing order of the neural processing unit 100 in consideration of the information about the data locality information or structure of the neural network model and the information about the data locality information or structure of the neural processing unit 100. Further, it is possible to optimize the processing of the neural processing unit 100 in the determined processing order.

That is, the NPU controller 130 may be configured to operate based on machine code compiled from a compiler, although in other examples, the NPU controller 130 may be configured to include an embedded compiler. According to the configurations described above, the neural processing unit 100 may be configured to generate machine code upon input of files in the form of frameworks of various AI software. For example, frameworks of AI software may include TensorFlow, PyTorch, Keras, XGBoost, mxnet, DARKNET, ONNX, and the like.

The plurality of processing elements 110 refers to a configuration of a plurality of processing elements PE1 to PE12 arranged to compute the feature map and weight data of the neural network. Each processing element may include a multiply and accumulate (MAC) operator and/or an arithmetic logic unit (ALU) operator. However, examples according to the present disclosure are not limited thereto.

Each processing element may be configured to optionally include additional special function units for processing additional special functions.

For example, the processing element (PE) may be modified to include a batch-normalization unit, an activation function unit, an interpolation unit, etc.

SFU 150 may include a plurality of circuits configured to selectively process activation function operations, pooling operations, stride operations, batch-normalization operations, skip-connection operations, concatenation operations, quantization operations, clipping operations, padding operations, and the like, according to the architecture of the neural network model. In other words, SFU 150 may include a plurality of special function operation processing circuit units.

While a plurality of processing elements are shown in FIG. 3 as an example, it is possible that a plurality of operators implemented as a plurality of multiplier and adder trees may be configured in parallel within a single processing element, replacing the MAC. In such cases, the plurality of processing elements 110 may also be referred to as at least one processing element comprising a plurality of operators.

The plurality of processing elements 110 is configured to include a plurality of processing elements PE1 to PE12. The plurality of processing elements PE1 to PE12 shown in FIG. 3 are examples for illustrative purposes only, and the number of the plurality of processing elements PE1 to PE12 is not limited. The number of the plurality of processing elements PE1 to PE12 may determine the size or number of the plurality of processing elements 110. The size of the plurality of processing elements 110 may be implemented in the form of an N x M matrix. Where N and M are integers greater than zero. The plurality of processing elements 110 may include N x M processing elements, i.e., there may be more than one processing element.

The size of the plurality of processing elements 110 can be designed considering the characteristics of the neural network model in which the neural processing unit 100 operates.

The plurality of processing elements 110 are configured to perform functions such as addition, multiplication, accumulation, and the like that are required for computing a neural network. In other words, the plurality of processing elements 110 may be configured to perform multiplication and accumulation (MAC) operations.

A first processing element PE1 of the plurality of processing elements 110 will be described below as an example.

The neural processing unit 100 according to examples of the present disclosure may be referred to as an AI semiconductor chip, an AI accelerator, a neural processor chip, and the like.

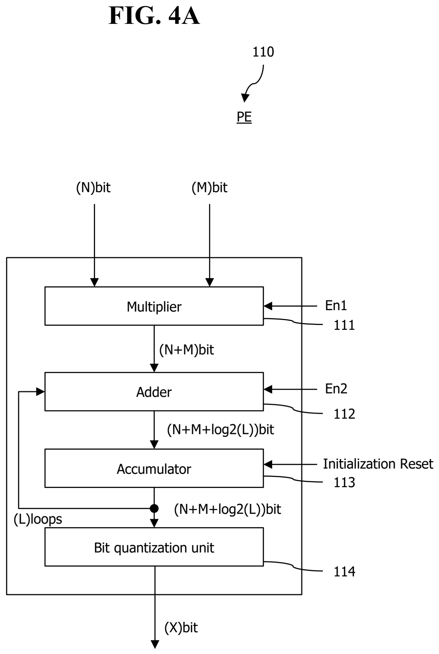

FIG. 4A is a schematic diagram illustrating a processing element of one of a plurality of processing elements that may be applied in one example of the present disclosure.

Referring to FIG. 4A, the processing element PE may be configured to include a multiplier 111, an adder 112, an accumulator 113, and a bit quantization unit 114. However, the examples according to the present disclosure are not limited thereto, and the plurality of processing elements may be modified to take into account the computational characteristics of the neural network model.

The multiplier 111 multiplies the input N-bit data with the M-bit data. The result of the multiplier 111 operation is output as (N+M)-bit data. Where N and M are integers greater than 0. The first input receiving the N-bit data may be configured to receive a variable parameter, and the second input receiving the M-bit data may be configured to receive a constant parameter. However, the input data to the multiplier 111 is not limited to a particular parameter. For example, a weight parameter learned in the neural network model may have a constant characteristic with respect to a processing element. For example, an input value (e.g., an activation parameter, a feature map parameter, an attention parameter, a KV cache parameter and the like.) that is computed by weight parameters in a neural network model may have a variable characteristic based on a processing element.

In other words, according to the examples of the present disclosure, the input data of the processing element can be operated by understanding the characteristics of the constant parameters and variable parameters, which can improve the computation efficiency of the neural processing unit 100. However, the neural processing unit 100 is not limited to the characterization of the constant parameters and variable parameters of the input data.

Here, the meaning of a parameter having a variable-like characteristic or the meaning of a variable means that, in the case of the value of the memory address where the value is stored, it is updated every time the incoming input data is updated. For example, the node data of each layer may be a MAC operation value reflecting the weight value of a neural network model, and when inferring object detection of video data with such a neural network model, the node data of each layer will change because the input video changes every frame.

Here, the meaning of a parameter having a constant-like characteristic or the meaning of a constant means that the value at the memory address where the parameter is stored is preserved regardless of the update of incoming input data. For example, the weight parameter of a connection network may be a unique inference judgment criterion of a neural network model, and the weight parameter of the connection network may not change over time even if the neural network model is used to infer object detection of video data and the like.

That is, the multiplier 111 may be configured to receive inputs of one variable and one constant. More particularly, the variable value input to the first input may be node data of a layer of the neural network model, wherein the node data may be input data of an input layer of the neural network model, accumulated values of a hidden layer, and accumulated values of an output layer. The constant value input to the second input may be weight data of a connection network of the neural network model.

The NPU controller 130 may be configured to take into account the nature of the constant values to improve memory reuse.

The variable values are the computation values of each layer, and the NPU controller 130 may recognize reusable variable values based on the machine code of the compiled neural network model, and control the NPU internal memory 120 to reuse the memory.

The constant value is the weight data of each connection network, and the NPU controller 130 may recognize the constant value of the repeatedly used connection network based on the structure data of the neural network model or the neural network data locality information, and control the NPU internal memory 120 to reuse the parameters stored in the NPU internal memory 120. Reusing the parameters means that the parameters stored in the NPU internal memory 120 are not deleted or otherwise copied or moved to the dedicated main memory 3000, but are reused in the next operation. According to the above-described configuration, it has the effect of reducing power consumption according to the operation of the main memory 3000 as shown in FIG. 4. Furthermore, it has the effect of eliminating a delay time that occurs when the neural processing unit 100 transmits data to and from the main memory 3000.

That is, the NPU controller 130 may know reusable variable parameters and reusable constant parameters based on the machine code of the compiled neural network model. Accordingly, the NPU controller 130 may be configured to control the NPU internal memory 120 to reuse the parameters stored in the memory.

The processing element may constrain the operation of the multiplier 111 such that when a zero is input to one of the inputs of the first input and the second input of the multiplier 111, the processing element knows that the result of the operation will be zero even if the operation is not performed.

For example, the multiplier 111 may be configured to operate in a zero-skipping manner when a zero is input to an input of one of the first input and the second input of the multiplier 111.

For zero-skipping, each of the processing elements PEs included in the plurality of processing elements 400 may be enabled or disabled, respectively. The NPU controller 130 may be configured to provide an enable or disable signal to each of the processing elements PEs on a clock-by-clock basis to each of the processing elements PEs. Here, when the processing element PE is disabled, the multiplier 111 may be configured to be disabled according to a level of the first enable signal En1. Accordingly, the power consumed by the operation of the multiplier 111 may be reduced. For example, information on the power consumption of the multiplier 111 may be provided with reference to FIG. 4.

For zero-skipping, each processing element PE included in the plurality of processing elements 400 may be enabled or disabled, respectively. The NPU controller 130 may be configured to provide an enable or disable signal to each processing element PE on a clock-by-clock basis to each processing element PE. Here, when the processing element PE is disabled, the adder 112 may be configured to deactivate according to a level of the second enable signal En2. Accordingly, the power consumed in the operation of the adder 112 may be reduced. For example, information about power consumption of the adder may be provided with reference to FIG. 4. In some examples, each processing element PE may be designed to receive a respective control signal from the NPU controller 130 for controlling (i.e., enabling or disabling) the zero-skipping operation.

In some examples, each multiplier 111 of each processing element PE may be designed to receive a respective control signal from the NPU controller 130 for controlling the zero-skipping operation. According to the configurations described above, the power consumption of the multipliers may be reduced by zero-skipping.

In some examples, each adder 112 of each processing element PE may be designed to receive a respective control signal from the NPU controller 130 for controlling the zero-skipping operation. According to the configurations described above, the power consumption of the adders may be reduced by zero-skipping.

In some examples, the respective multipliers 111 and adders 112 of each processing element PE may be designed to simultaneously receive respective control signals for controlling zero-skipping operations from the NPU controller 130. According to the above-described configuration, the power consumption of the multipliers and adders may be reduced by zero-skipping.

In some examples, the weights are constant parameters that have been trained, and the machine code compiled with the neural network model comprising the weights may be programmed to input respective control signals for controlling the zero-skipping operation to respective processing elements PEs where values with zero weights are input.

The number of bits of data input to the first input and the second input may be determined according to the quantization of the node data and the weight data of the respective layers of the neural network model. For example, the node data of the first layer may be quantized to 5 bits and the weight data of the first layer may be quantized to 7 bits. In such a case, the first input may be configured to receive 5-bit data and the second input may be configured to receive 7-bit data, i.e., the number of bits of data input to each input may be different.

The processing elements PEs may be configured to be provided with quantization information of data input to their respective inputs. The neural network data locality information may include quantization information of input data of the processing element PE and output data of the processing element PE.

The neural processing unit 100 may control that the quantized data stored in the NPU internal memory 120 is converted in real time when the quantized bit width is input to the inputs of the processing element. That is, different layers may have different quantized bit width, and the processing element may be configured to receive bit width information from the neural processing unit 100 in real time as the bit width of the incoming data is converted, and to convert the bit width in real time to generate the input data.

The accumulator 113 uses the adder 112 for (L) number of loops to accumulate the operation value of the multiplier 111 and the operation value of the accumulator 113. Thus, the number of bits of data at the output and input of the accumulator 113 may be output as (N+M+log2(L)) bits. Here, L is an integer greater than zero.

When the accumulator 113 terminates accumulation, the accumulator 113 may receive an initialization reset signal to initialize the data stored inside the accumulator 113 to zero. However, examples according to the present disclosure are not limited thereto.

The accumulator 113 is configured to store the accumulated value even when zero-skipping is enabled in the corresponding processing element PE. Thus, subsequent values can be accumulated even when zero-skipping is activated.

The bit quantization unit 114 may reduce the number of bits in the data output from the accumulator 113. The bit quantization unit 114 may be controlled by the NPU controller 130. The number of bits of quantized data may be output as X-bits. Here, X is an integer greater than zero. According to the configuration described above, the plurality of processing elements are configured to perform a MAC operation, and the plurality of processing elements have the effect of quantizing and outputting the results of the MAC operation. In particular, such quantization has the effect of further reducing power consumption as the number of (L) loops increases. Reducing power consumption also has the effect of reducing the heat generation of edge devices. In particular, reducing heat generation has the effect of reducing the possibility of malfunctioning of the neural processing unit 100 due to high temperature.

The output data X-bits of the bit quantization unit 114 may be the node data of the next layer or the input data of a convolutional product. If the neural network model is quantized, the bit quantization unit 114 may be configured to receive quantized information from the neural network model. However, without limitation, the NPU controller 130 may also be configured to analyze the neural network model to extract the quantized information. Accordingly, the output data X-bits may be converted to a number of quantized bits to correspond to the quantized data size. The output data X-bits of the bit quantization unit 114 may be stored in the NPU internal memory 120 as a quantized number of bits.

The plurality of processing elements of the neural processing unit 100 according to one example of the present disclosure may include a multiplier 111, an adder 112, an accumulator 113, and a bit quantization unit 114. The plurality of processing elements may reduce a number of bits of data of (N+M+log2(L)) bits output from the accumulator 113 by the bit quantization unit 114 to a number of bits of X-bits. The NPU controller 130 may control the bit quantization unit 114 to reduce the number of bits of the output data by a predetermined number of bits from the least significant bit (LSB) to the most significant bit (MSB). Reducing the number of bits in the output data may have the effect of reducing power consumption, computation, and memory usage. However, if the number of bits is reduced below a certain length, the inference accuracy of the neural network model may decrease rapidly. Therefore, the quantization level, i.e., the reduction of the number of bits in the output data, can be determined by comparing the degree of reduction in power consumption, computation, and memory usage with the degree of reduction in the inference accuracy of the neural network model. The quantization degree may be determined by determining a target inference accuracy of the neural network model and testing the neural network model with a progressively reduced number of bits. The quantization degree may be determined for each layer of the neural network model separately.

According to the processing element PE described above, by adjusting the number of bits of N-bit data and M-bit data of the multiplier 111 and reducing the number of bits of the operation value X-bit by the bit quantization unit 114, the plurality of processing elements has the effect of improving the MAC operation speed while reducing the power consumption, and also has the effect of making the convolution operation of the neural network model more efficient.

FIG. 4B is a schematic diagram illustrating a special function unit (SFU) that may be applied in one example of the present disclosure.

Referring to FIG. 4B, the SFU 150 may include multiple functional units. Each functional unit may be selectively operable. Each functional unit may be selectively turned on or off, i.e., each functional unit may be configurable.

In other words, the SFU 150 may include a variety of computation units necessary for performing neural network inference operations.

For example, the circuit units of the SFU 150 may include functional units for skip-connection operations, functional units for activation function operations, functional units for pooling operations, functional units for quantization/dequantization operations, a function unit for non-maximum suppression (NMS) operations, a function unit for softmax function operations, a function unit for batch-normalization operations, a function unit for interpolation operations, a function unit for concatenation operations, and a function unit for bias operations.

The functional units of the SFU 150 may be selectively turned on or off based on the data locality information of the neural network model. The data locality information of the neural network model may include control information associated with turning on or off the corresponding functional units when operations for a particular layer are performed.

Among the functional units of the SFU 150, the active units may be turned on. In this way, selectively turning off some functional units of the SFU 150 may reduce power consumption of the neural processing unit 100. Alternatively, power gating may be utilized to turn off some functional units. Alternatively, clock gating may be utilized to turn off some functional units.

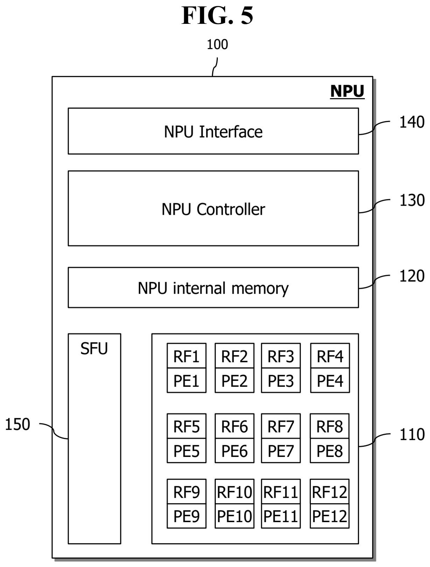

FIG. 5 is a schematic diagram illustrating a variation of the neural processing unit shown in FIG. 3.

The neural processing unit 100 shown in FIG. 5 is substantially the same as the processing unit 100 exemplarily shown in FIG. 3, with the exception of the plurality of processing elements 110, which may be omitted herein for ease of description.

In addition to the plurality of processing elements PE1 to PE12, the plurality of processing elements 110 illustrated as an example in FIG. 5 may further include respective register files RF1 to RF12 corresponding to each of the processing elements PE1 to PE12.

The plurality of processing elements PE1 to PE12 and the plurality of register files RF1 to RF12 illustrated in FIG. 5 are examples for illustrative purposes only, and the number of the plurality of processing elements PE1 to PE12 and the plurality of register files RF1 to RF12 is not limited.

The size or number of the plurality of processing elements 110 may be determined by the number of the plurality of processing elements PE1 to PE12 and the plurality of register files RF1 to RF12. The size of the plurality of processing elements 110 and the plurality of register files RF1 to RF12 may be implemented in the form of an N x M matrix. Here, N and M are integers greater than zero.

The size of the array of the plurality of processing elements 110 may be designed in consideration of the characteristics of the neural network model on which the neural processing unit 100 operates. As will be described further, the memory size of the register file may be determined by considering the data size of the neural network model to be operated, the required operation speed, the required power consumption, and the like.

The register files RF1 to RF12 of the neural processing unit 100 are static memory units directly associated with the processing elements PE1 to PE12. The register files RF1 to RF12 may comprise, for example, flip-flops and/or latches. The register files RF1 to RF12 may be configured to store MAC operation values of the corresponding processing elements PE1 to PE12. The register files RF1 to RF12 may be configured to provide or receive weight data and/or node data with the NPU internal memory 120.

The register files RF1 to RF12 can also be configured to function as temporary memory for the accumulator during MAC operations.

The neural processing unit 100 according to examples of the present disclosure may be referred to as an AI semiconductor chip, an AI accelerator, a neural processor chip, and the like.

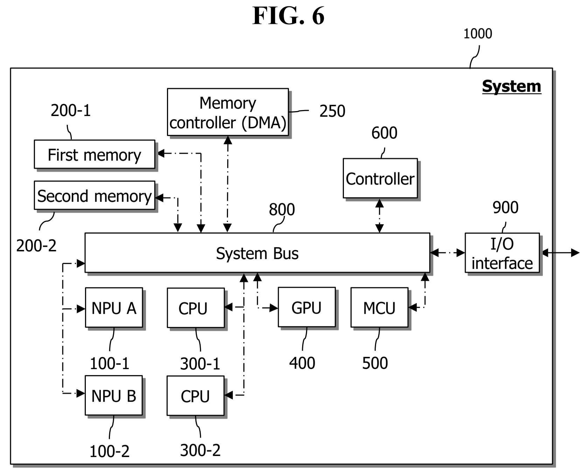

FIG. 6 is a block diagram illustrating a system according to one example.

Referring to FIG. 6, a system 1000 may include at least one of: one or more NPUs 100-1, 100-2 and one or more memories 200-1, 200-2 mounted on a substrate, a memory controller 250, one or more CPUs 300-1, 300-2, one or more graphic processing units (GPUs) 400, one or more microcontroller units (MCUs) 500, a controller 600, a system bus 800, and an input output (I/O) interface 900. Here, the NPU and CPU may be integrated on a single semiconductor chip or may be implemented as a chiplet.

However, it will be appreciated that certain circuits in the configuration of the system 1000 may be selectively excluded according to the operation scenario of a particular application where certain functionality is unnecessary.

The system bus 800 may be implemented by electrically conductive patterns formed on the substrate or semiconductor die. The system bus 800 may enable high-speed communication. For example, the one or more NPUs 100-1, 100-2 and the one or more memories 200-1, 200-2, the memory controller 250, the one or more CPUs 300-1, 300-2, the one or more GPUs 400, and the one or more MCUs 500 may communicate via the system bus 800.

The one or more NPUs 100-1, 100-2 and the one or more memories 200-1, 200-2, the memory controller 250, the one or more CPUs 300-1, 300-2, the one or more GPUs 400, and the one or more MCUs 500 may be semiconductors implemented as electrical/electronic circuits. That is, the one or more NPUs 100-1, 100-2, the one or more memories 200-1, 200-2, the memory controller 250, the one or more CPUs 300-1, 300-2, the one or more GPUs 400, and the one or more MCUs 500 may be semiconductor circuits with numerous electronic elements (e.g., transistors, capacitors) connected thereto.

The one or more NPUs 100-1, 100-2 and the one or more memories 200-1, 200-2, the memory controller 250, the one or more CPUs 300-1, 300-2, the one or more GPUs 400, and the one or more MCUs 500 make a request to the memory controller 250 via the system bus 500, whereby the memory controller 250 may read and/or write data from at least one of the plurality of memories 200-1, 200-2.

Among the above plurality of NPUs, the first NPU 100-1 may be an NPU of type A, and the second NPU 100-2 may be an NPU of type B.

Among the plurality of CPUs, the first CPU 100-1 may be a CPU based on an X86 architecture, and the second CPU 300-2 may be a CPU based on an ARM architecture. According to another example, the first CPU 300-1 may be a CPU based on an ARM architecture, and the second CPU 300-2 may be a CPU based on an X86 architecture or a CPU based on a RISC-V architecture.

On the other hand, the system 1000 may be implemented in the form of a system on chip (SoC). An SoC refers to a semiconductor that contains an entire system on a single chip, and refers to a technology in which major semiconductor elements such as processing unit, memory unit, and data bus unit are implemented on a single chip. SiP refers to a semiconductor that packages an entire system into a single package, and refers to a technology in which processing unit, memory unit, and data bus unit are implemented in a single package.

The neural processing unit 100 according to examples of the present disclosure may be referred to as an AI semiconductor, an AI accelerator, neural processor chip, and the like. The system 1000 including the neural processing unit 100 according to examples of the present disclosure may be referred to as an SoC, SiP, an AI processor package, an AI semiconductor, an AI accelerator, a neural processor chip, and the like.

### <Semiconductor packages>

In general, semiconductor chips are integrated with numerous fine electrical circuits, but they cannot serve as semiconductor products by themselves, and there is a possibility that they may be damaged by external physical or chemical impacts. Therefore, instead of using semiconductor chips as naked, semiconductor chips are packaged and used in electronic devices.

Semiconductor packaging is required due to the disparity in circuit pitch between semiconductor chips and the mainboards of electronic devices, which must be resolved to enable reliable electrical interconnection. Specifically, in the case of semiconductor chips, the size of the connection pads and the spacing between the connection pads are very small, while in the case of mainboards used in electronic devices, the size of the component mounting pads and the spacing between the component mounting pads are much larger than the scale of semiconductor chips. Therefore, it is difficult to mount semiconductor chips directly on such mainboards, and packaging technology that can buffer the difference in circuit width between the two is required.

Semiconductor packages can first be categorized into conventional packages, where the package process is performed by cutting the wafer into chips, and wafer-level packages, where some or all of the package process is performed at the wafer level and later cut into discrete pieces.

Conventional packages can be classified into ceramic packages and plastic packages based on the material used for packaging. Plastic packages are electrically connected by attaching a diced chip, and can be further classified based on the type of substrate employed: leadframe-type packages that use a leadframe, and substrate-type packages that use a substrate.

A wafer-level package refers to a semiconductor package that is completed at the wafer level. Wafer-level packages include: (i) Re-distribution layer (RDL), which reconfigures the chip's input/output pads for external electrical connection through wafer-level processing; (ii) Flip chip packages, in which solder bumps are formed directly on the wafer for packaging; (iii) Wafer level chip scale packages (WLCSP), in which interconnections and solder balls are formed directly on the wafer without a substrate to complete the package; and (iv) Through-silicon via (TSV) packages, which enable vertical electrical connections between stacked chips using TSV electrodes. WLCSPs can further be classified into fan-in and fan-out types. Fan-in WLCSPs form interconnects and solder balls directly on the wafer, within the chip's footprint. In contrast, fan-out WLCSPs involve redistributing singulated chips into a reconstituted (molded) wafer, followed by wafer-level wiring and the formation of solder balls, thereby enabling a package size larger than the individual chip.

A wafer-level package is a package that has been processed at the wafer level. Wafer-level packages include the Re-Distribution Layer (RDL), which rearranges the pads on the chip that electrically connect to the outside world through a wafer-level process, and Flip Chip packages, which package by forming solder bumps on the wafer, Wafer Level Chip Scale Package (WLCSP), which forms wiring and solder balls on the wafer without a substrate to complete the package, and TSV package, which provides internal connectivity of stacked chips through through-silicon-via electrodes (TSV). WLCSPs can further be categorized into fan-in WLCSPs, which attach wiring and solder balls directly on the wafer, and fan-out WLCSPs, which rearrange chips into a molded wafer and form wiring in a wafer-level process to attach solder balls to a package larger than the chip size.

The term fan refers to the physical footprint of the chip. A fan-in wafer-level chip scale package (WLCSP) is configured such that all solder balls are placed within the area of the original chip. In contrast, a fan-out WLCSP extends the package size beyond the chip footprint, allowing solder balls to be placed outside the original chip boundary.

In summary, a package according to one example of the present disclosure may comprise at least one memory chip and at least one neural processor chip. The package may be implemented as either a conventional package or a wafer-level package. The conventional package may be realized using ceramic or plastic packaging. The wafer-level package may be implemented as a chip-scale package, a WLCSP, or a through-silicon via (TSV) package.

In the following, fan-in semiconductor packages and fan-out semiconductor packages will be discussed in more detail with reference to the drawings.

### I. Fan-in Semiconductor Packages

A fan-in wafer-level chip scale package (WLCSP) is a type of package in which the interconnect wiring, insulation layers, and solder balls required for external connectivity are formed directly on the surface of the wafer, without extending beyond the original chip footprint.

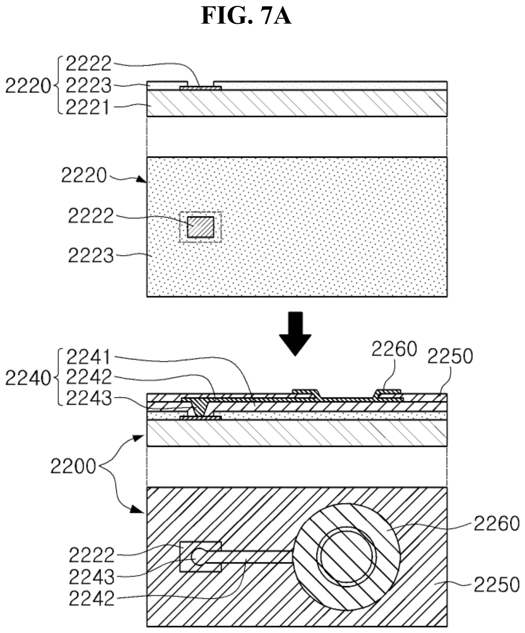

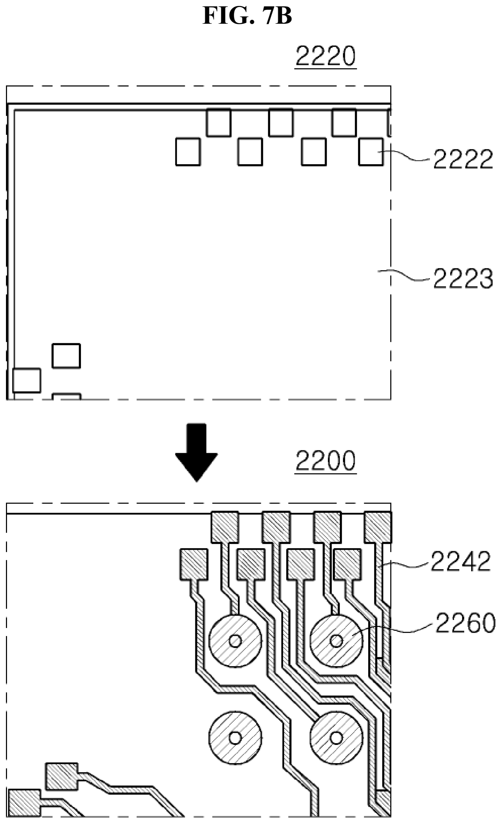

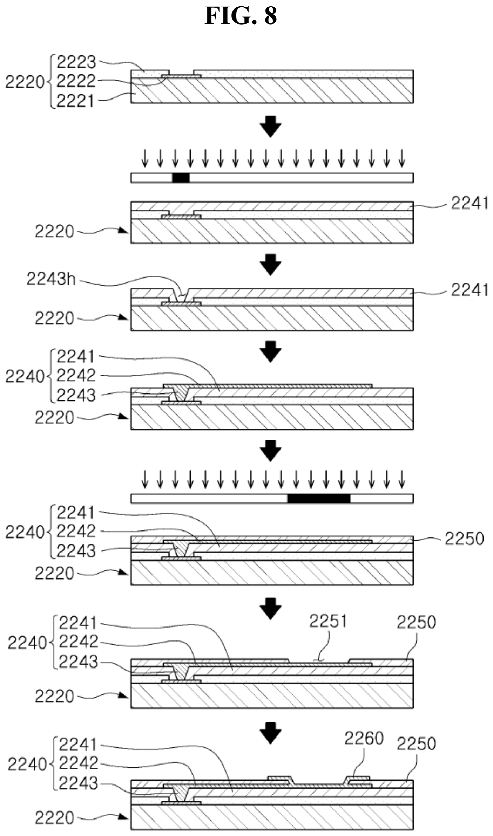

FIGS. 7A and 7B are cross-sectional views illustrating before and after packaging of a fan-in semiconductor package. and FIG. 8 is a cross-sectional view illustrating a packaging process of a fan-in semiconductor package.

Referring to the accompanying drawings, a semiconductor chip 2220 comprises a body 2221 including at least a portion of silicon dioxide (SiO₂), silicon (Si), germanium (Ge), or gallium arsenide (GaAs); a junction pad 2222 formed on a first surface of the body 2221, comprising at least a portion of a conductive material such as copper (Cu), titanium (Ti), or aluminum (Al); and a passivation film 2223, such as an oxide film, a nitride film, or a bare metal film, which covers at least a portion of the junction pad 2222 and is also formed on the first surface of the body 2221. The semiconductor chip 2220 may be an integrated circuit (IC) in a bare die state. In such a case, due to the extremely small size of the junction pad 2222, the IC is difficult to mount directly on a mid-level printed circuit board (PCB), and even more so on a main board of an electronic device.

Accordingly, in order to redistribute the connection pad 2222, a connection member 2240 may be formed on the semiconductor chip 2220 in accordance with the dimensions of the semiconductor chip 2220. The connection member 2240 may be fabricated by forming an insulating layer 2241, comprising an insulating material such as a photosensitive insulating resin (PID), over the semiconductor chip 2220, creating a via hole 2243 to expose the connection pad 2222, and subsequently forming a wiring pattern 2242 and filling the via hole 2243. Thereafter, a passivation layer 2250 for protecting the connection member 2240 may be formed, followed by the formation of an opening 2251 and an under-bump metallization pad (underbump pad) 2260. Through this series of processes, a fan-in semiconductor package 2200 comprising the semiconductor chip 2220, the connection member 2240, the passivation layer 2250, and the underbump pad 2260 may be completed.

In further detail, semiconductor chips may be electrically connected to a main board as well as to other semiconductor chips. However, the circuit pattern pitch of the main board cannot be fabricated as finely as that of semiconductor chips. For instance, the pitch between terminals of a semiconductor chip is approximately 100 micrometers (µm), whereas the pitch between terminals of the main board is approximately 350 micrometers, representing a difference of approximately four times. Accordingly, an intermediate structure is required to bridge this mismatch, which is referred to as the package substrate. The package substrate performs a rewiring function by connecting each terminal of the semiconductor chip to the corresponding terminal on the main board through conductive traces having a wider line width.

A fan-in semiconductor package refers to a packaging configuration in which the connection pads of a semiconductor chip-such as input/output (I/O) terminals-are arranged entirely within the footprint of the device. The fan-in semiconductor package exhibits favorable electrical characteristics and offers cost-efficient manufacturability.

The fan-in semiconductor package format provides advantages in terms of compact form factor and high-speed signal transmission capability.

However, the fan-in configuration is subject to spatial limitations because all I/O terminals must be confined within the semiconductor chip area. As a result, such a structure is not well-suited for semiconductor chips that require a large number of I/O terminals or for chips with very small physical dimensions. Even when the I/O terminals are redistributed via a rewiring process to increase their size and pitch, it may remain difficult to achieve terminal dimensions and spacing that enable direct mounting onto a main board of an electronic device.

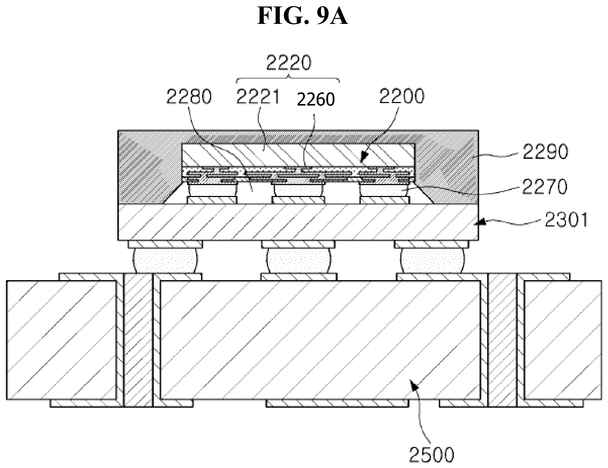

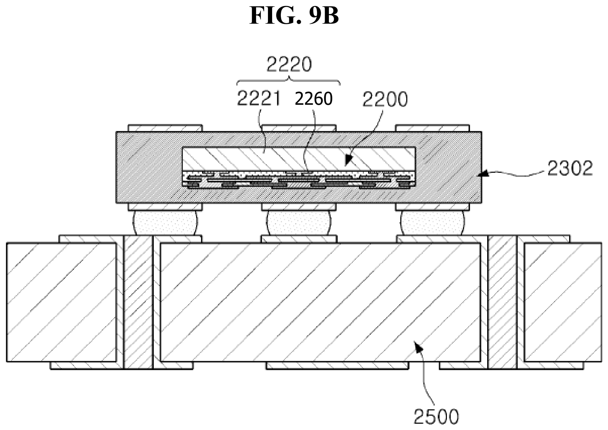

FIG. 9A is a cross-sectional view of a fan-in semiconductor package mounted on an interposer substrate and mounted on a main board of an electronic device, and FIG. 9B is a cross-sectional view of a fan-in semiconductor package embedded within an interposer substrate and mounted on a main board of an electronic device.

Referring to the accompanying drawings, the fan-in semiconductor package 2200 may be mounted via the underbump pad 2260 of the semiconductor chip 2220. The input/output (I/O) terminals of the semiconductor chip 2220 may be further rewired through an interposer substrate 2301. Subsequently, the fan-in semiconductor package 2200, having been mounted on the interposer substrate 2301, may be mounted on the main board 2500 of the electronic device. In such a configuration, solder balls 2270 or equivalent conductive elements may be fixed using an underfill resin 2280 or the like, and the outer periphery may be encapsulated with a molding compound 2290 or equivalent sealing material. Alternatively, the fan-in semiconductor package 2200 may be embedded within a separate interposer substrate 2302, and while in the embedded state, the access pads 2222, i.e., the I/O terminals of the semiconductor chip 2220, may be rewired by means of the interposer substrate 2302 and ultimately mounted on the main board 2500 of the electronic device.

As described above, fan-in semiconductor packages are not directly mounted on the main board of an electronic device. Instead, such packages may be mounted on a separate interposer substrate, subsequently repackaged, and then mounted on the main board of the electronic device. Alternatively, the fan-in semiconductor packages may be embedded within the interposer substrate and mounted on the main board of the electronic device in that embedded state.

The neural processing unit 100, according to one example of the present disclosure, may be implemented in the form of a fan-in semiconductor package.

A package according to various examples of the present disclosure, by including the neural processing unit 100, may be referred to as an AI processor package.

### II. Fan-out Semiconductor Packages

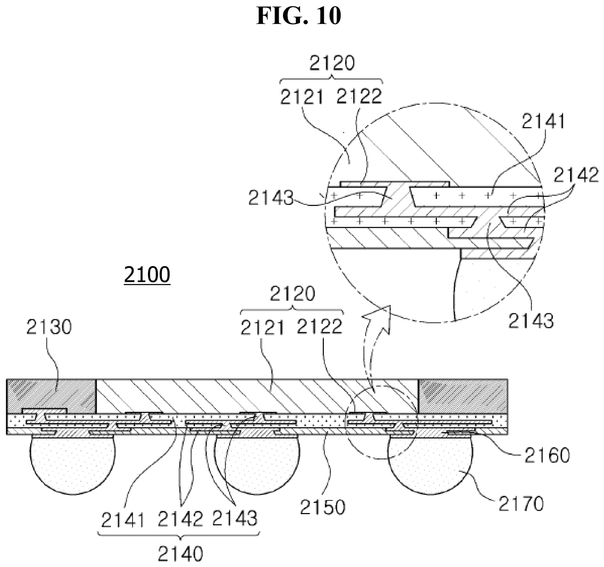

FIG. 10 is a cross-sectional view of a fan-out semiconductor package.

Referring to the accompanying drawing, a fan-out semiconductor package 2100 may be provided. The fan-out semiconductor package 2100 may include a semiconductor chip 2120, a suture material 2130, a connection member 2140, an underbump pad 2160, and a solder ball 2170. The semiconductor chip 2120 may include a body 2121 and at least one connection pad 2122 formed on one surface thereof. An outer side of the semiconductor chip 2120 may be protected by the suture material 2130. The connection pad 2122 may be electrically connected to the outer side of the semiconductor chip 2120 by the connection member 2140. The connection member 2140 may include an insulating layer 2141, a rewiring layer 2142 disposed on the insulating layer 2141, and at least one via 2143 configured to electrically connect the connection pad 2122 to the rewiring layer 2142. A passivation layer 2202 may be formed on the connection member 2140. The underbump pad 2160 may be formed in an opening defined in the passivation layer 2202. The solder ball 2170 may be formed on the underbump pad 2160. The semiconductor chip 2120 may further include a passivation layer (not shown) and other constituent elements.

In such a manufacturing process, the connection member 2140 may be formed after the suture material 2130 is formed on the outer side of the semiconductor chip 2120. In this case, the connection member 2140 may be formed to include the via 2143 and the rewiring layer 2142, which are configured to be electrically connected to the connection pad 2122 of the semiconductor chip 2120. The via 2143 may be formed to have a width that becomes smaller as the via 2143 is positioned closer to the semiconductor chip 2120 (see enlarged area).

As such, the fan-out semiconductor package may be implemented in a form in which input/output (I/O) terminals of a semiconductor chip are rearranged to an outer region of the semiconductor chip through a connection member formed thereon. As described above, in a fan-in semiconductor package, a standardized solder ball layout may not be employable, since all of the I/O terminals of the semiconductor chip may be disposed in an inner region of the semiconductor chip. Accordingly, the size and pitch of the solder balls may be reduced as the size of the device becomes smaller. On the other hand, in a fan-out semiconductor package, the I/O terminals of the semiconductor chip may be redistributed to an outer region of the semiconductor chip through the connection member, such that a standardized solder ball layout may be employable even when the size of the semiconductor chip becomes smaller. As will be described later, the fan-out semiconductor package may be directly mountable on a main board of an electronic device without requiring a separate interposer board.

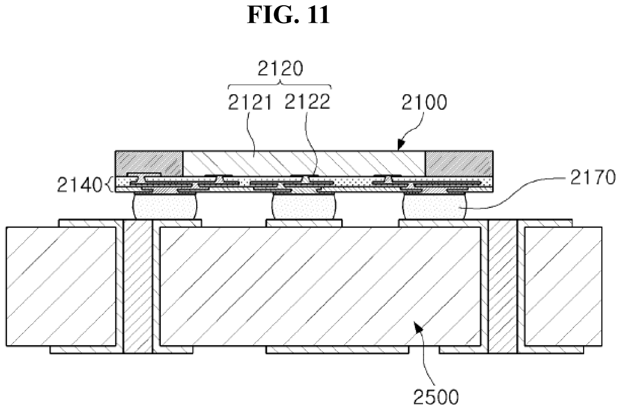

FIG. 11 is a cross-sectional view of a fan-out semiconductor package mounted on a main board of an electronic device.

Referring to the drawings, the fan-out semiconductor package 2100 may be mounted on a main board 2500 of an electronic device through solder balls 2170 or similar conductive structures. That is, as described above, the fan-out semiconductor package 2100 may utilize a standardized solder ball layout on the semiconductor chip 2120, since the fan-out semiconductor package 2100 includes a connection member 2140 configured to rewire connection pads 2122 to a fan-out region extending beyond an outer perimeter of the semiconductor chip 2120.

As a result, the fan-out semiconductor package 2100 may be mounted on the main board 2500 of the electronic device without requiring a separate interposer substrate or similar intermediate component. Accordingly, the fan-out semiconductor package may be mounted directly on the main board of an electronic device, thereby eliminating the need for a separate interposer substrate, and enabling overall downsizing and thinning of the package structure compared to fan-in semiconductor packages employing interposer substrates.

Moreover, the fan-out semiconductor package may exhibit superior thermal and electrical performance characteristics, rendering it particularly suitable for use in on-devices. In addition, the fan-out semiconductor package may be more compactly implemented than a conventional package-on-package (PoP) type structure employing a printed circuit board (PCB), and issues associated with warpage may be mitigated.

On the other hand, a fan-out semiconductor package may refer to a packaging technology in which semiconductor chips are mounted on a main board of an electronic device and protected from external mechanical impact. The fan-out semiconductor package may be distinguished from printed circuit boards (PCBs), such as interposer substrates used in fan-in semiconductor packages, in that the fan-out semiconductor package may differ in scale, structure, and functional application.

A neural processing unit 100 according to one example of the present disclosure may be implemented in a fan-out semiconductor package.

A package according to various examples of the present disclosure may be referred to as an artificial intelligence (AI) processor package when the package includes the neural processing unit 100.

### III. Package on Package (PoP)

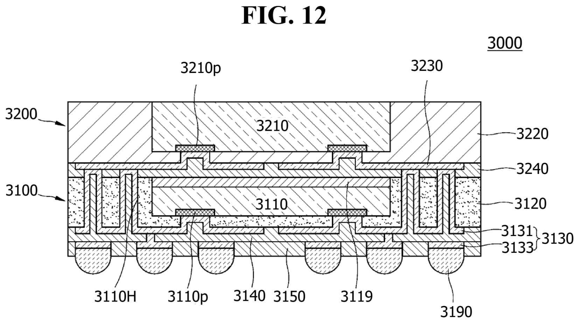

FIG. 12 is a cross-sectional view of a package-on-package according to a first example.

Referring to FIG. 12, a package-on-package (PoP) 3000 is formed by attaching a second package 3200 to a first package 3100.

The first package 3100 may be a semiconductor package, such as a fan-out wafer level package (FOWLP). The second package 3200 may also be a FOWLP or, alternatively, a fan-in package. The first package 3100 includes a first semiconductor chip 3110.

The substrate forming the first semiconductor chip 3110 may be a semiconductor substrate or a glass substrate.

The semiconductor substrate of the first semiconductor chip 3110 has an active side and an opposite inactive side. The first semiconductor chip 3110 contains semiconductor devices, comprising various individual devices, formed on the active side.

The glass substrate may include silica (SiO₂) and boron oxide (B₂O₃). Physical and electrical properties of the glass substrate may be optimized by controlling the content of these components. Specific properties may be further enhanced through the doping of additional metal oxides. Furthermore, the glass substrate may also include alumina (Al₂O₃). Silica (SiO₂) may be included at a content of 60% to 80%, and may facilitate high heat resistance and mechanical strength while reducing dielectric loss. Boron oxide (B₂O₃) may be included at a content of 10% to 25%, and may lower the coefficient of thermal expansion and improve workability. It may also provide a high dielectric constant and contribute to mechanical strength. Alumina (Al₂O₃) may be included at a content of 0% to 10%, and may enhance chemical durability and improve mechanical strength. It may also increase the dielectric constant. Metal oxides for property adjustment may include titania (TiO₂), strontium oxide (SrO), magnesia (MgO), and calcium oxide (CaO). Titania (TiO₂) may be included at a content of 1% to 5%, and may increase the dielectric constant while maintaining mechanical strength. Strontium oxide (SrO) may be included at a content of 1% to 5%, and may improve highfrequency signal properties and facilitate low dielectric loss. Magnesia (MgO) may be included at a content of 0% to 5%, and may reduce dielectric loss and increase heat resistance. Calcium oxide (CaO) may be included at a content of 0% to 3%, and may reduce dielectric loss and supplement thermal stability.

The first semiconductor chip 3110 may include a plurality of pads 3110p, which are electrically coupled to the semiconductor devices within the chip. The first semiconductor chip 3110 is not limited to a single chip and can, for example, be a stack of multiple semiconductor chips.

In some exemplary embodiments, the first semiconductor chip 3110 may be a memory semiconductor chip, such as static random-access memory (SRAM).

Alternatively, in other exemplary embodiments, the first semiconductor chip 3110 may be a logic chip. Examples of logic chips include a neural processing unit (NPU), an image signal processor (ISP), a central processing unit (CPU), a microprocessor unit (MPU), a graphics processing unit (GPU), or an application processor (AP).

The first package 3100 can also include a first sealing layer 3120. This layer covers at least a portion of the first semiconductor chip 3110, potentially including a side and the bottom side where the pads 3110p are located. The first sealing layer 3120 features an opening to expose the pads 3110p of the first semiconductor chip 3110.

The first sealing layer 3120 may include an insulating material. The first sealing layer 3120 may also include a through-hole 3120H that perpendicularly penetrates the layer. This through-hole 3120H may be situated in a peripheral portion of the first semiconductor chip 3110.

The first package 3100 may include first rewiring structure 3130 and 3140, which are provided on the first semiconductor chip 3110. These first rewiring structure may comprise a first rewiring pattern 3130 and a first isolation pattern 3140.

The first sealing layer 3120 may include an insulating material. The first sealing layer 3120 may also include a through-hole 3120H that perpendicularly penetrates the layer. This through-hole 3120H may be situated in a peripheral portion of the first semiconductor chip 3110.

The first package 3100 may include first rewiring structure 3130 and 3140, which are provided on the first semiconductor chip 3110. The first rewiring structure may comprise a first rewiring pattern 3130 and a first isolation pattern 3140.

The first rewiring pattern 3130 may electrically connect a pad 3110p of the first semiconductor chip 3110 to the external connection terminal 3190. Further, the first rewiring pattern 3130 may be electrically connected to the second rewiring pattern 3230. Through the first rewiring pattern 3130 and the second rewiring pattern 3230, the first semiconductor chip 3110 and the second semiconductor chip 3210 may be electrically connected, and the second semiconductor chip 3210 may be electrically connected to the external connection terminal 3190.

More specifically, the first rewiring pattern 3130 may comprise a plurality of sub-rewiring patterns, wherein the sub-rewiring patterns may have a multi-layered structure. For example, the first rewiring pattern 3130 may include a first sub-rewiring pattern 3131 and a second sub-rewiring pattern 3133. The first sub-rewiring pattern 3131 may be formed on the first sealing layer 3120 and may be connected to a pad 3110p of the first semiconductor chip 3110. A portion of the first sub-rewiring pattern 3131 may be connected to the second rewiring pattern 3230 through the first sealing layer 3120 and the second insulation pattern 3240. The second sub-rewiring pattern 3133 may extend over the first insulation pattern 3140 and may be connected to the first sub-rewiring pattern 3131 via the first insulation pattern 3140.

The first insulation pattern 3140 may be provided on the underside of the first sealing layer 3120. The first insulation pattern 3140 may cover the first sub-rewiring pattern 3131, but may have openings that expose portions of the first sub-rewiring pattern 3131.

A protective layer 3150 may be formed over the first insulation pattern 3140. The protective layer 3150 may expose a portion of the second sub-rewiring pattern 3133. External connection terminal3190 may be disposed on the portion of the second sub-rewiring pattern 3133 exposed by the protective layer 3150. The external connection terminal3190 may be, for example, solder balls, bumps, copper pillar bumps, or copper-to-copper direct bonding. The external connection terminal3190 may provide an electrical connection between the package-on-package (PoP) 3000 and an external device.

The second package 3200 may be disposed on top of the first package 3100. The second package 3200 may include a second semiconductor chip 3210. The second semiconductor chip 3210 may include a pad 3210p. The second semiconductor chip 3210 may be a single semiconductor chip or a stack of a plurality of semiconductor chips.

In exemplary embodiments, the second semiconductor chip 3210 may be at least one memory semiconductor chip. Alternatively, the second semiconductor chip 3210 may be a logic chip.

The second package 3200 may include a second sealing layer 3220 covering at least a portion of the second semiconductor chip 3210. For example, the second sealing layer 3220 may cover a side and the bottom side of the second semiconductor chip 3210 where the pad 3210p is provided. The second sealing layer 3220 may have an opening to expose the pad 3210p of the second semiconductor chip 3210.

In this regard, the second sealing layer 3220 may not cover the upper surface of the second semiconductor chip 3210.

The second sealing layer 3220 may include an insulating material. In exemplary embodiments, the second sealing layer 3220 may include a photosensitive material. For example, the second sealing layer 3220 may be composed of a polymer material such as polyimide. However, the material composing the second sealing layer 3220 is not limited hereto, and for example, the second sealing layer 3220 may also include Epoxy Molding Compound (EMC).

The second package 3200 may include second rewiring structure 3230 and 3240 provided between the second sealing layer 3220 and the first sealing layer 3120. The second rewiring structure 3230 and 3240 may include a second rewiring pattern 3230 and a second insulation pattern 3240. The second rewiring pattern 3230 may extend along the surface of the second sealing layer 3220 and may be electrically connected to the pad 3210p of the second semiconductor chip 3210.

In embodiments, the electrical connection between the second package 3200 and the first package 3100 may be made via a connection of the first rewiring pattern 3130 and the second rewiring pattern 3230.

The package-on-package (PoP) 3000 does not include inter-package connection terminals, such as solder balls for connecting the second package 3200 to the first package 3100, which can simplify the semiconductor package manufacturing process and allow for the manufacture of semiconductor packages in the form of a thinner PoP.

In general, in the case of a semiconductor package in the form of a PoP in which a plurality of packages are stacked, there has been a problem that warpage of the semiconductor package causes damage, such as cracks, to the inter-package connection terminals, thereby reducing the reliability of the semiconductor package. However, in exemplary embodiments, the second package 3200 and the first package 3100 can be electrically connected without inter-package connection terminal (e.g., solder balls) that are vulnerable to warpage, further improving the reliability of the semiconductor package.

According to one example of the present disclosure, the second package 3200 includes the neural processing unit 100, and the first package 3100 may be configured to include one or more memory chips.

According to one example of the present disclosure, the first package 3100 may include the neural processing unit 100, and the second package 3200 may be configured to include one or more memory chips. Here, if the neural processing unit 100 generates more heat than the memory, it may be advantageous for the neural processing unit 100 to be located above the memory.

A package according to various examples of the present disclosure may be referred to as an AI processor package by including a neural processing unit 100.

Furthermore, the technical features of the different examples of the present disclosure may be combined with each other to form variations.

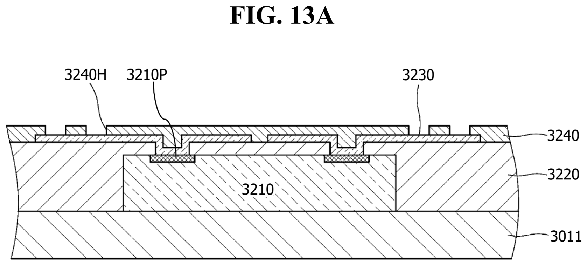

FIGS. 13A through 13D are cross-sectional views illustrating a method of manufacturing the package on package (PoP) 3000 shown in FIG. 12.

Referring to FIG. 13A, a second semiconductor chip 3210 is disposed on the carrier 3011, and a second sealing layer 3220 may be formed covering the second semiconductor chip 3210. The second sealing layer 3220 may be formed to cover a side and a surface of the second semiconductor chip 3210 on which the pad 3210p is provided. In example embodiments, to form the second sealing layer 3220, an insulating layer may be applied over the carrier 3011 and the second semiconductor chip 3210, and a portion of the insulating layer may be removed to expose the pad 3210p of the second semiconductor chip 3210. The insulating layer may comprise, for example, a photosensitive material.

After forming the second sealing layer 3220, second rewiring structure 3230 and 3240 may be formed on the second sealing layer 3220 and the second semiconductor chip 3210. Specifically, a second rewiring pattern 3230 may be formed on the top of the second sealing layer 3220 and on the pad 3210p of the second semiconductor chip 3210. For example, the second rewiring pattern 3230 may be formed via a seed film formation process, a mask process, and an electroplating process. After forming the second rewiring pattern 3230, the second insulation pattern 3240 may be formed by depositing an insulating film on the second sealing layer 3220 and the second rewiring pattern 3230, and forming an opening 3240H by removing a portion of the insulating film to expose a portion of the second rewiring pattern 3230.

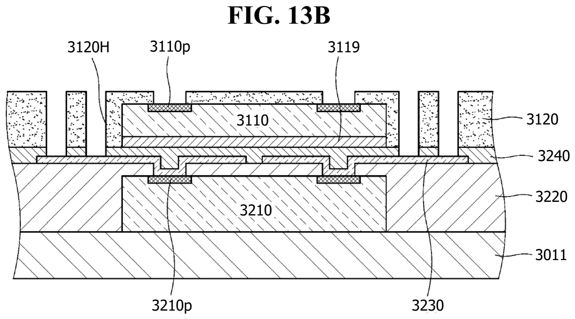

Referring to FIG. 13B, the first semiconductor chip 3110 is disposed on the second insulating pattern 3240. Between the first semiconductor chip 3110 and the second insulation pattern 3240, an adhesive layer 3119 may be provided for securing the first semiconductor chip 3110. The adhesive layer 3119 may include, for example, a die attach film, and may comprise a material having high thermal conductivity such that heat from the first semiconductor chip 3110 is effectively dissipated.

After placing the first semiconductor chip 3110, a first sealing layer 3120 covering the first semiconductor chip 3110 may be formed. The first sealing layer 3120 may include an opening to expose the pad 3110p of the first semiconductor chip 3110, and may include a through-hole 3120H that penetrates the layer to expose the second rewiring pattern 3230. The first sealing layer 3120 may be formed by applying an insulating film to the first semiconductor chip 3110, removing a portion of the insulating film to expose the pad 3110p of the first semiconductor chip 3110, and forming a through-hole 3120H to vertically penetrate the insulating film and expose the second rewiring pattern 3230.

In exemplary embodiments, the first sealing layer 3120 may be formed through a lamination process utilizing a polymeric material, such as polyimide, covering the sides of the first semiconductor chip 3110 and the surface with the pads 3110p. In this case, compared to forming a mold material covering the sides of the first semiconductor chip 3110 followed by sequentially forming an insulating material on its bottom surface, the first sealing layer 3120, which covers the sides and the surface with the pads 3110p, may be formed through a single lamination process, potentially simplifying the semiconductor package manufacturing process.

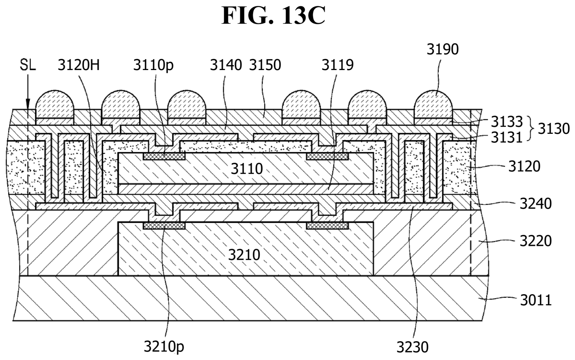

Referring to FIG. 13C, first rewiring structure 3130 and 3140 may be formed on the first sealing layer 3120 and the first semiconductor chip 3110. To form the first rewiring structure 3130 and 3140, a first sub-rewiring pattern 3131, a first insulation pattern 3140, and a second sub-rewiring pattern 3133 may be formed sequentially. More specifically, the first sub-rewiring pattern 3131 may be formed on the first sealing layer 3120, abutting the pad 3110p of the first semiconductor chip 3110, and extending through the through-hole 3120H of the first sealing layer 3120 to abut the second rewiring pattern 3230. For example, the first sub-rewiring pattern 3131 may be formed via a seed film forming process, a masking process, and an electroplating process. After forming the first sub-rewiring pattern 3131, the first insulation pattern 3140 may be formed by depositing an insulating film on the first sealing layer 3120 and the first sub-rewiring pattern 3131, and removing a portion of the insulating film to form an opening that exposes a portion of the first sub-rewiring pattern 3131. After forming the first insulation pattern 3140, a second sub-rewiring pattern 3133 may be formed on the first insulation pattern 3140. The second sub-rewiring pattern 3133 may be formed to be connected to the first sub-rewiring pattern 3131 through the first insulating pattern 3140.

For example, the second sub-rewiring pattern 3133 may be formed via a seed film formation process, a mask process, and an electroplating process.

A protective layer 3150 may then be formed over the first insulation pattern 3140. This protective layer 3150 may include openings that expose portions of the second sub-rewiring pattern 3133. External connection terminal3190 may be attached to the exposed portions of the second sub-rewiring pattern 3133. The external connection terminal3190 may be, for example, solder balls or bumps.

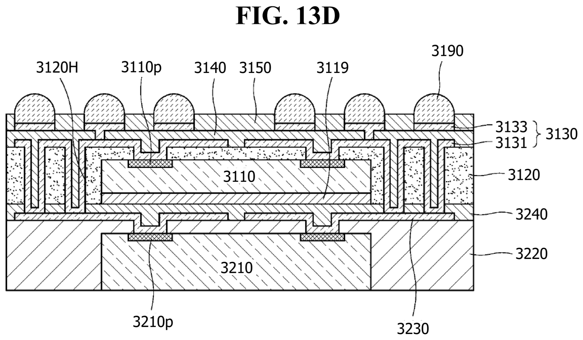

Referring now to FIG. 13D, the carrier (3011 of FIG. 13C) may be removed. The semiconductor package may then be separated into individual semiconductor packages by a sawing process. This involves cutting the package shown in FIG. 13C according to the scribe lines (FIG. 13C, SL) to separate it into a plurality of individual semiconductor packages.

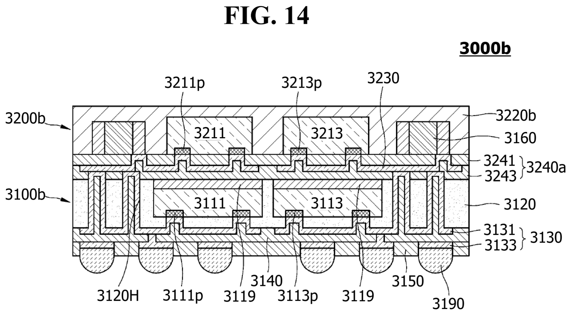

FIG. 14 is a cross-sectional view of a package-on-package according to a second example.

Referring to FIG. 14, descriptions redundant with the foregoing description are omitted or abbreviated for conciseness.

Referring to FIG. 14, the semiconductor package-on-package 3000b may include a first package 3100b and a second package 3200b.

The first package 3100b may be a semiconductor package, for example, in the form of a FOWLP.

The first package 3100b may include a plurality of semiconductor chips 3111 and 3113.

For example, the first package 3100b may include horizontally spaced-apart semiconductor chips, such as a first lower semiconductor chip 3111 and a second lower semiconductor chip 3113. These chips may be homogeneous or dissimilar semiconductor chips.

The first package 3100b may include a first sealing layer 3120 covering at least portions of the first lower semiconductor chip 3111 and the second lower semiconductor chip 3113. The first sealing layer 3120 may include an insulating material. For example, the first sealing layer 3120 may comprise a photosensitive polymeric material such as polyimide.

The second package 3200b may include a plurality of semiconductor chips 3211 and 3213.

For example, the second package 3200b may include horizontally spaced-apart semiconductor chips, such as a first top semiconductor chip 3211 and a second top semiconductor chip 3213. These chips may be homogeneous or dissimilar semiconductor chips.

Furthermore, in exemplary embodiments, the second package 3200b may be a semiconductor package in the form of a system in package, which may include various circuit elements, such as passive elements 3160, that perform functions like signal processing. The passive elements 3160 may include resistors, capacitors, inductors, diodes, piezoelectric components, and the like.

The second package 3200b may include a second sealing layer 3220b covering at least a portion of the first top semiconductor chip 3211 and at least a portion of the second top semiconductor chip 3213. The second sealing layer 3220b may be filled between the first top semiconductor chip 3211 and the second top semiconductor chip 3213. In exemplary embodiments, the second sealing layer 3220b may be made of materials such as EMC.

According to one example, a first package 3100b of the semiconductor package-on-package 3000b may include a neural processing unit 100, and a second package 3200b may include one or more memory chips. Here, if the neural processing unit 100 generates more heat than the memory, it may be advantageous for the neural processing unit 100 to be located above the memory.

Furthermore, the technical features of the different examples of the present disclosure may be combined with each other to form variations.

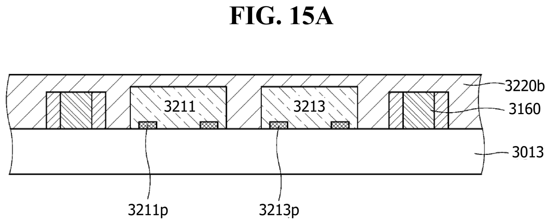

FIGS. 15A through 15E illustrate a method of manufacturing the package-on-package (PoP) 3000b shown in FIG. 14.

Referring to FIG. 15A, a first upper semiconductor chip 3211 and a second upper semiconductor chip 3213 are disposed on the support substrate 3013. Subsequently, a second sealing layer 3220b may be formed on the support substrate 3013, covering the first upper semiconductor chip 3211 and the second upper semiconductor chip 3213. In exemplary embodiments, the second sealing layer 3220b may include an EMC. Alternatively, the second sealing layer 3220b may include an insulating layer comprising a photosensitive material, similarly to the second sealing layer 3220 described with reference to FIG. 13A.

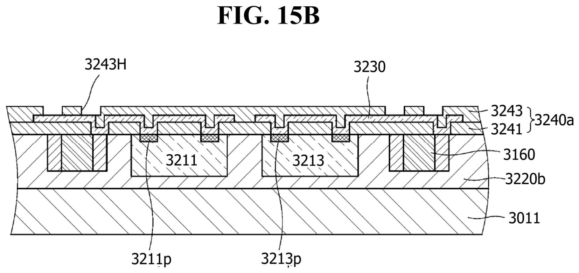

Referring to FIG. 15B, the support substrate 3013 may be removed from the resultant structure shown in FIG. 15A. The resultant structure may then be inverted and placed on the carrier 3011.

Subsequently, the second rewiring structure 3230 and 3240a may be formed on the second sealing layer 3220b, the first upper semiconductor chip 3211, and the second upper semiconductor chip 3213. To form these second rewiring structure 3230 and 3240a, the first sub-insulation pattern 3241, the second rewiring pattern 3230, and the second sub-insulation pattern 3243 may be formed sequentially. More specifically, the first sub-insulation pattern 3241 may be formed as an insulating film on the first upper semiconductor chip 3211 and the second upper semiconductor chip 3213, with openings formed therein to expose the pads 3211p of the first upper semiconductor chip 3211 and the pads 3213p of the second upper semiconductor chip 3213. After forming the first sub-insulation pattern 3241, a second rewiring pattern 3230 may be formed on the first sub-insulation pattern 3241. For example, the second rewiring pattern 3230 may be formed via a seed film formation process, a mask process, and an electroplating process. After forming the second rewiring pattern 3230, a second sub-insulation pattern 3243 covering the second rewiring pattern 3230 may be formed on the first sub-insulation pattern 3241. The second sub-insulation pattern 3243 may include an opening 3243H for exposing a portion of the second rewiring pattern 3230.

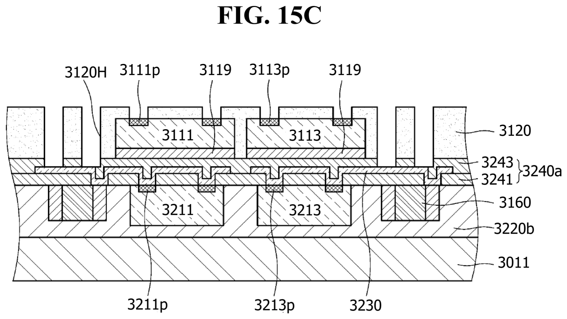

Referring to FIG. 15C, the first lower semiconductor chip 3111 and the second lower semiconductor chip 3113 are disposed on the second sub-insulation pattern 3243. An adhesive layer 3119 may be provided between the lower semiconductor chips 3111, 3113 and the second sub-insulation pattern 3243 to secure the first lower semiconductor chip 3111 and the second lower semiconductor chip 3113.

After placement of the first lower semiconductor chip 3111 and the second lower semiconductor chip 3113, a first sealing layer 3120 covering these chips may be formed. The first sealing layer 3120 may include a through-hole 3120H vertically penetrating the layer, and openings exposing pads 3111p of the first lower semiconductor chip 3111 and pads 3113p of the second lower semiconductor chip 3113. These features may be formed via a method similar to that described with reference to FIG. 13B.

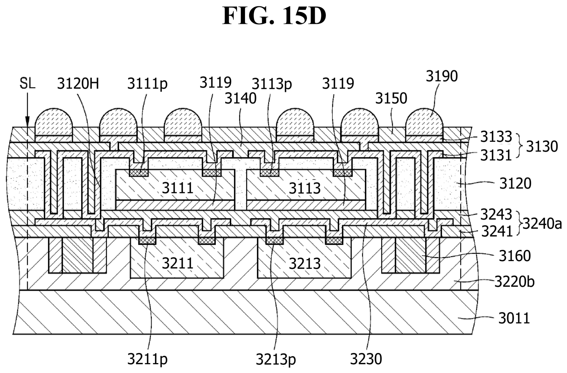

Referring to FIG. 15D, first rewiring structure 3130 and 3140 may be formed on the first sealing layer 3120, the first lower semiconductor chip 3111, and the second lower semiconductor chip 3113. To form these first rewiring structure 3130 and 3140, the first sub-rewiring pattern 3131, the first insulation pattern 3140, and the second sub-rewiring pattern 3133 may be formed sequentially using a method similar to that described with reference to FIG. 13C.

An external connection terminal 3190 may then be formed on the second sub-rewiring pattern 3133 exposed by the opening in the protective layer 3150. This may be performed using a method similar to that described with reference to FIG. 13C.

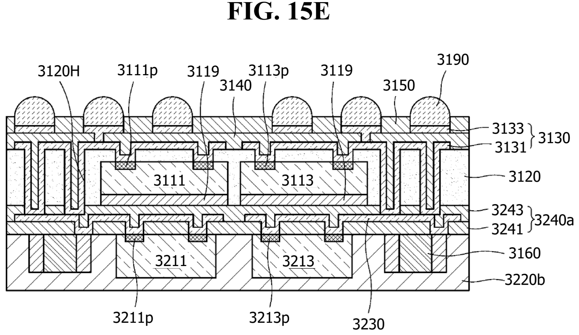

Referring to FIG. 15E, the carrier (3011 of FIG. 15D) may be removed. The semiconductor package shown in FIG. 15D may then be separated into a plurality of individual semiconductor packages by cutting according to the scribe lines (FIG. 15D, SL).

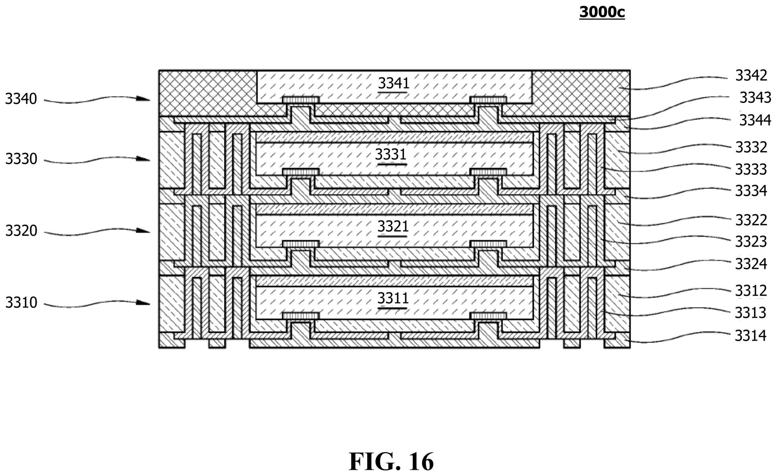

FIG. 16 is a cross-sectional view of a package-on-package according to a third example.

FIG. 16 is a cross-sectional view illustrating a semiconductor package-on-package 3000c according to exemplary embodiments of the present disclosure. For conciseness, descriptions redundant with the foregoing description are omitted or abbreviated with reference to FIG. 16.

Referring to FIG. 16, the semiconductor package-on-package 3000c may comprise a first package 3310, a second package 3320, a third package 3330, and a fourth package 3340 stacked vertically. Each of the first package 3310, the second package 3320, the third package 3330, and the fourth package 3340 may be a semiconductor package in a FOWLP form.

The first package 3310 may include a first semiconductor chip 3311, a first sealing layer 3312, and a first rewiring structure 3313, 3314; the second package 3320 may include a second semiconductor chip 3321, a second sealing layer 3322, and a second rewiring structure 3323, 3324; and the third package 3330 may include a third semiconductor chip 3331, a third sealing layer 3332, and a third rewiring structure 3333, 3334.

For example, the first package 3310, the second package 3320, and the third package 3330 may have technical features similar to the first package 3100 described with reference to FIG. 12; accordingly, a detailed description is therefore omitted.

The fourth package 3340 may include a fourth semiconductor chip 3341, a fourth sealing layer 3342, and a fourth rewiring structure 3343, 3344. For example, the fourth package 3340 may have technical features similar to the second package 3200 described with reference to FIG. 12; accordingly, a detailed description is omitted.

The first semiconductor chip 3311 in the first package 3310, the second semiconductor chip 3321 in the second package 3320, the third semiconductor chip 3331 in the third package 3330, and the fourth semiconductor chip 3341 in the fourth package 3340 may be homogeneous or heterogeneous semiconductor chips.

In exemplary embodiments, electrical connections between the first through fourth semiconductor chips 3311, 3321, 3331, and 3341 may be implemented via the rewiring patterns and insulation layers of the stacked packages. Specifically, electrical connection between the first package 3310 and the second package 3320 may be made via the first rewiring pattern 3313 extending through the first sealing layer 3312 and the second insulation pattern 3324. Connection between the second package 3320 and the third package 3330 may be made via the second rewiring pattern 3323 extending through the second sealing layer 3322 and the third insulation pattern 3334. Connection between the third package 3330 and the fourth package 3340 may be made via the third rewiring pattern 3333 extending through the third sealing layer 3332 and the fourth insulation pattern 3344. The fourth rewiring pattern 3343 of the fourth package 3340 may also contribute to these connections.

The first through fourth packages 3310, 3320, 3330, 3340 may be electrically connected without inter-package connections susceptible to warping, thus providing increased reliability for the semiconductor package.

In addition, multiple packages may be stacked without inter-package connections, which may enable the manufacture of thinner semiconductor packages.

The semiconductor package-on-package 3000c according to one example of the present disclosure may include a plurality of stacked packages. In this example, the first package 3310 may comprise the neural processing unit 100, and the second through fourth packages 3320, 3330, and 3340 may comprise one or more memory chips. Here, if the neural processing unit 100 generates more heat than the memory, it may be advantageous for the neural processing unit 100 to be located above the memory.

Furthermore, the technical features of the different examples of the present disclosure may be combined with each other to form variations.

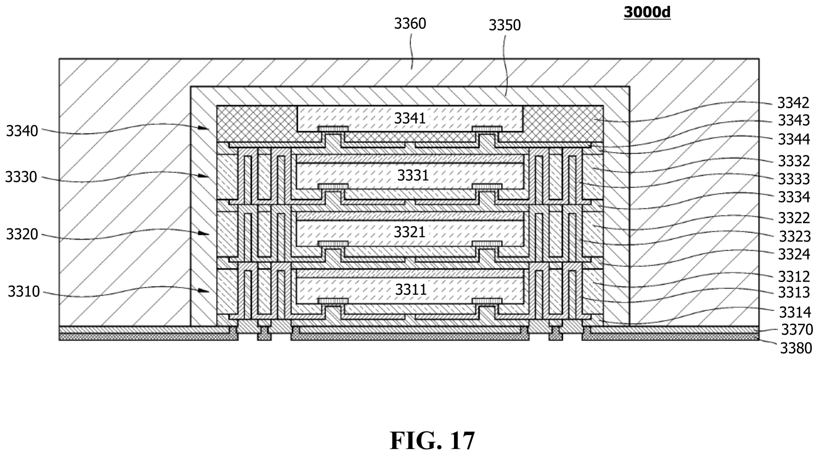

FIG. 17 is a cross-sectional view illustrating a package-on-package according to a fourth example. Referring now to FIG. 17, for conciseness, descriptions redundant with the foregoing description are omitted or abbreviated.

Referring to FIG. 17, a semiconductor package-on-package 3000d according to a fourth example may comprise a first package 3310, a second package 3320, a third package 3330, and a fourth package 3340 stacked vertically.

For example, the first through fourth packages 3310, 3320, 3330, and 3340 may have technical features similar to the semiconductor package-on-package 3000c described with reference to FIG. 16; accordingly, a detailed description may not repeat here.

The semiconductor package-on-package 3000d may include an electromagnetic shielding layer 3350 covering at least a portion of the vertically stacked first package 3310, second package 3320, third package 3330, and fourth package 3340.

For example, as shown, the electromagnetic shielding layer 3350 may cover a sidewall of each of the first package 3310, the second package 3320, the third package 3330, and the fourth package 3340, and may cover a top surface of the stack. The electromagnetic shielding layer 3350 may shield electromagnetic interference (EMI), thereby reducing performance degradation of the semiconductor package-on-package 3000d due to EMI.

The semiconductor package-on-package 3000d may include an outer sealing layer 3360 that covers the electromagnetic shielding layer 3350 covering the first to fourth packages 3310, 3320, 3330, and 3340. In exemplary embodiments, the outer sealing layer 3360 may include a material having good thermal conductivity, which may improve the heat dissipation properties of the semiconductor package-on-package 3000d.

The semiconductor package-on-package 3000d may include a bottom conductive layer 3370 and a thermal conductive film 3380 provided on a surface of the first package 3310 and on a surface of the outer sealing layer 3360.

The lower conductive layer 3370 may extend along a surface of the first insulation pattern 3314 of the first package 3310, a surface of the outer sealing layer 3360, and/or a surface of the electromagnetic shielding layer 3350 between the first package 3310 and the outer sealing layer 3360.

A portion of the lower conductive layer 3370 extending according to the first insulation pattern 3314 may be connected to the first rewiring pattern 3313 of the first package 3310 through an opening in the first insulation pattern 3314.

Additionally, a portion of the lower conductive layer 3370 may be connected to the electromagnetic shielding layer 3350 and may function as an electrical path for grounding electromagnetic waves incident on the electromagnetic shielding layer 3350.

For example, the lower conductive layer 3370 may include a conductive material.

The thermal conductive film 3380 may be provided on a surface of the first insulation pattern 3314 of the first package 3310, on a surface of the outer sealing layer 3360, and/or on a surface of the electromagnetic shielding layer 3350 between the first package 3310 and the outer sealing layer 3360. The thermal conductive film 3380 may cover the underlying conductive layer 3370 but may include openings that expose portions of the underlying conductive layer 3370.

For example, the thermal conductive film 3380 may include an insulating material having good thermal conductivity.

The semiconductor package-on-package 3000d according to one example of the present disclosure may include a plurality of stacked packages. In this example, the first package 3310 may comprise the neural processing unit 100, and the second through fourth packages 3320, 3330, and 3340 may comprise one or more memory chips. Here, if the neural processing unit 100 generates more heat than the memory, it may be advantageous for the neural processing unit 100 to be located above the memory.

The semiconductor package-on-package 3000d may be configured to include at least one of an electromagnetic shielding layer 3350, an outer sealing layer 3360, a lower conductive layer 3370, and a thermal conductive film 3380 associated with the plurality of stacked packages 3310, 3320, 3330, and 3340.

Furthermore, the technical features of the different examples of the present disclosure may be combined with each other to form variations.

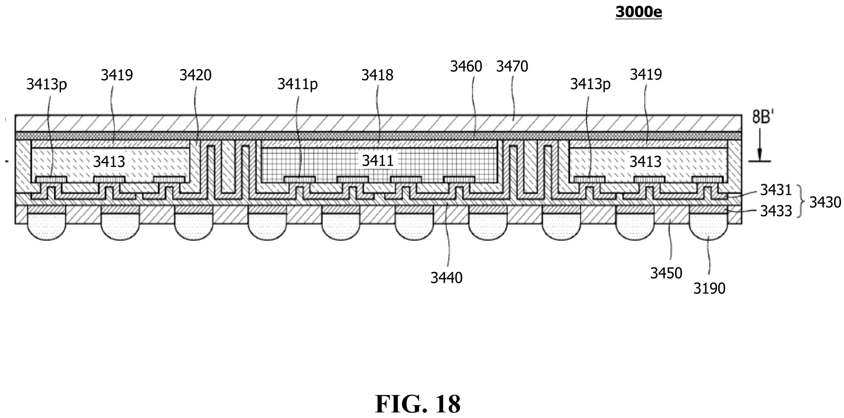

FIG. 18 is a cross-sectional view illustrating a package according to a fifth example.

Referring to FIG. 18, a package 3000e according to a fifth example may include a first semiconductor chip 3411 and a second semiconductor chip 3413. The package 3000e may be a system-in-package in which the first semiconductor chip 3411, the second semiconductor chip 3413, and similar components are packaged in a fan-out manner.

In exemplary embodiments, the first semiconductor chip 3411 may be a logic chip. For example, the first semiconductor chip 3411 may be an NPU, or alternatively, a CPU, MPU, GPU, or AP.

In exemplary embodiments, the second semiconductor chip 3413 may be a memory semiconductor chip.

In exemplary embodiments, the second semiconductor chip 3413 may have a cavity to accommodate the first semiconductor chip 3411. For example, the second semiconductor chip 3413 may be disposed on a periphery of the first semiconductor chip 3411.

The package 3000e, according to a fifth example, may include a sealing layer 3420 that molds the first semiconductor chip 3411 and the second semiconductor chip 3413 such that they are integrated. The sealing layer 3420 may cover at least a portion of the first semiconductor chip 3411 and at least a portion of the second semiconductor chip 3413. For example, the sealing layer 3420 may cover the sidewalls and the underside of the first semiconductor chip 3411 where the pads 3411p are provided, and may cover the sidewalls and the underside of the second semiconductor chip 3413 where the pads 3413p are provided.

The package 3000e according to a fifth example may include a rewiring structure 3430, 3440. The rewiring structure 3430, 3440 may include a rewiring pattern 3430 and an insulation pattern 3440.

The rewiring pattern 3430 may electrically connect the pads 3411p of the first semiconductor chip 3411 to the external connection terminal 3190, and may electrically connect the pads 3413p of the second semiconductor chip 3413 to the external connection terminal 3190. The rewiring pattern 3430 may have a multilayer structure. For example, the rewiring pattern 3430 may include a first sub-rewiring pattern 3431 and a second sub-rewiring pattern 3433. The first sub-rewiring pattern 3431 may extend along a surface of the sealing layer 3420, and may be connected to the pads 3411p of the first semiconductor chip 3411, and may be connected to the pads 3413p of the second semiconductor chip 3413. Further, a portion of the first sub-rewiring pattern 3431 may extend vertically through the sealing layer 3420.

The insulation pattern 3440 is provided on the underside of the sealing layer 3420, and may cover at least a portion of the first sub-rewiring pattern 3431.

A protective layer 3450 may be formed over the insulation pattern 3440. The protective layer 3450 may cover the second sub-rewiring pattern 3433 but may include openings that expose portions of the second sub-rewiring pattern 3433. External connection terminals 3190 may be disposed on the portions of the second sub-rewiring pattern 3433 exposed by the protective layer 3450.

On the upper surface of the first semiconductor chip 3411 and the upper surface of the second semiconductor chip 3413, a heat conduction film 3460 and a heat sink 3470 may be provided. An adhesive layer 3418 may be provided between the upper surface of the first semiconductor chip 3411 and the heat conduction film 3460 to secure the first semiconductor chip 3411. An adhesive layer 3419 may be provided between the upper surface of the second semiconductor chip 3413 and the heat conduction film 3460 to secure the second semiconductor chip 3413. In exemplary embodiments, the adhesive layers 3418 and 3419 may comprise a material having excellent thermal conductivity, thereby improving heat dissipation for the first semiconductor chip 3411 and the second semiconductor chip 3413.

The package 3000e, according to one example of the present disclosure, may include a plurality of horizontally spaced semiconductor chips. In this example, the package 3000e may include a neural processing unit 100 and one or more memory chips. The neural processing unit 100 may be located in the center of the package 3000e, and the memory may be disposed on a periphery of the neural processing unit 100. The package 3000e may comprise at least a portion of a semiconductor package-on-package.

Furthermore, the technical features of the different examples of the present disclosure may be combined with each other to form variations.

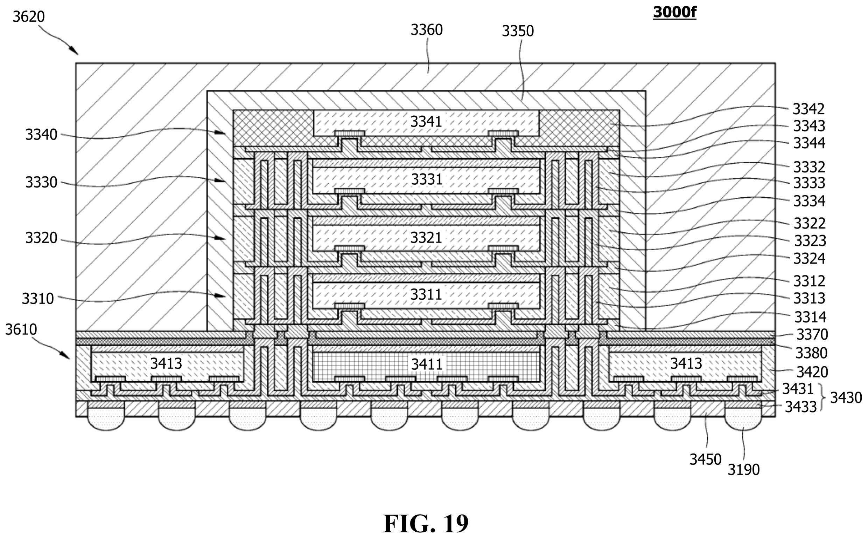

FIG. 19 is a cross-sectional view illustrating a package-on-package according to the sixth example. In FIG. 19, for conciseness, descriptions redundant with the foregoing description are omitted or abbreviated.

Referring now to FIG. 19, the semiconductor package-on-package 3000f according to a sixth example may include a lower package 3610 and an upper package 3620. Because the lower package 3610 may have substantially the same configuration as the package 3000e shown in FIG. 18, and the upper package 3620 may have substantially the same configuration as the semiconductor package-on-package 3000d shown in FIG. 17, a detailed description of the lower package 3610 and the upper package 3620 will be omitted.

As shown in FIG. 19, the first sub-rewiring pattern 3431 provided in the lower package 3610 may extend through the sealing layer 3420 and the heat conduction film 3380 of the lower package 3610, and may be connected to the lower conductive layer 3370 of the upper package 3620. That is, electrical connection between the first semiconductor chip 3411 of the lower package 3610 and the semiconductor chips 3311, 3321, 3331, and 3341 of the upper package 3620 may be made via the rewiring pattern 3430 of the lower package 3610, the lower conductive layer 3370 of the upper package 3620, and the first to fourth rewiring patterns 3313, 3323, 3333, and 3343 of the upper package 3620.

In exemplary embodiments, the first semiconductor chip 3411 of the lower package 3610 may be an NPU, and the semiconductor chips 3311, 3321, 3331, and 3341 of the upper package 3620 may be one or more memory semiconductor chips configured to transmit and receive electrical signals to and from the first semiconductor chip 3411 of the lower package 3610.

In exemplary embodiments of the present disclosure, the lower package 3610 and the upper package 3620 may be electrically connected without inter-package connection terminals that are susceptible to warping, thereby making the semiconductor package-on-package 3000F more reliable. Furthermore, since multiple packages may be stacked without inter-package connection terminals, a thinner semiconductor package may be manufactured.

In exemplary embodiments of the present disclosure, the lower package 3610 and the upper package 3620 may be electrically connected without inter-package connection terminals that are susceptible to warping, thereby making the semiconductor package-on-package 3000f more reliable. Furthermore, since multiple packages may be stacked without inter-package connection terminals, a thinner semiconductor package may be manufactured.

Here, the neural processing unit 100 can be positioned in the center of the package 3000e, and the memory can be positioned on the periphery of the neural processing unit 100.

Furthermore, the technical features of the different examples of the present disclosure may be combined with each other to form variations.

A semiconductor package-on-package 3000f according to one example of the present disclosure may include a plurality of stacked packages. In this example, the package 3000f may include one or more neural processing units 100 and one or more memory chips. The bottommost package 3610 of the semiconductor package-on-package 3000f may be a package comprising a plurality of horizontally spaced semiconductor chips (e.g., similar to package 3000e). Although a plurality of vertically stacked packages (e.g., second through fourth packages 3320, 3330, and 3340 as described with reference to FIG. 16) are shown here as part of the upper package 3620, the package comprising the memory chips may be a stack of one or more packages. Here, if the neural processing unit 100 generates more heat than the memory, it may be advantageous for the neural processing unit 100 to be located above the memory. For example, the topmost semiconductor chip 3341 may be the neural processing unit 100.

The semiconductor package-on-package 3000f may be configured to include at least one of an electromagnetic shielding layer 3350, an outer sealing layer 3360, a lower conductive layer 3370, and a thermal conductive film 3380 associated with the plurality of stacked packages 3610, 3310, 3320, 3330, and 3340.

Furthermore, the technical features of the different examples of the present disclosure may be combined with each other to form variations.

### IV. 2.5D Package

Unlike 3D packaging, where multiple semiconductor dies are stacked vertically, 2.5D packaging typically involves arranging multiple dies laterally on an interposer, with memory dies potentially stacked on the logic dies or the interposer.

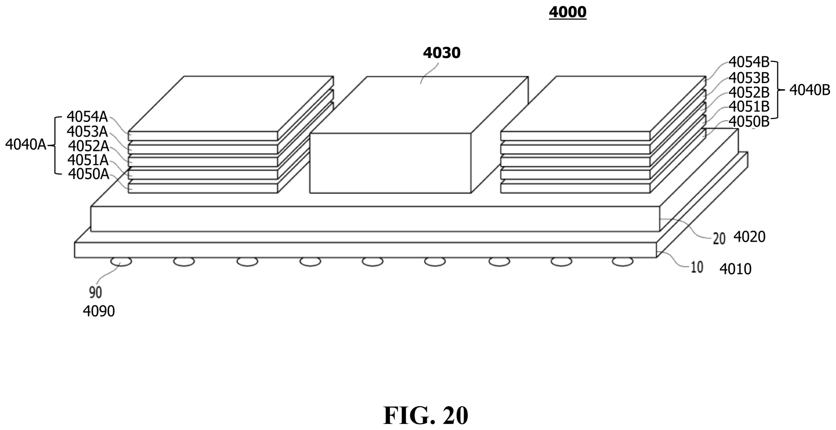

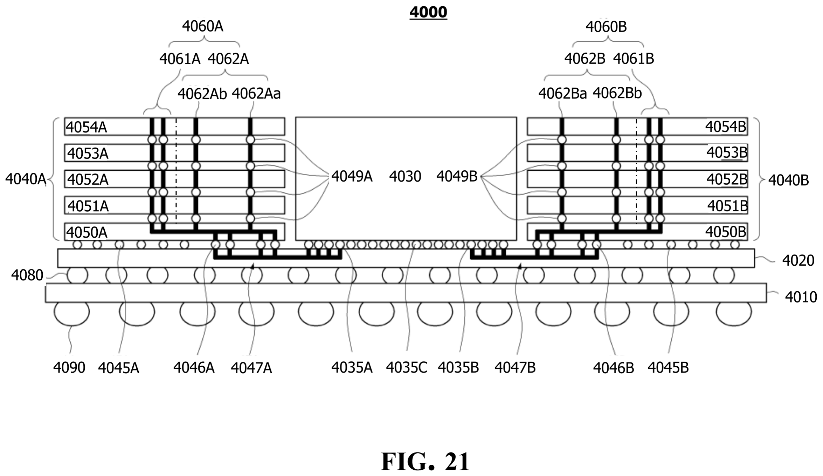

FIG. 20 is a schematic perspective view of a semiconductor package 4000 according to a 2.5D package method, and FIG. 21 is a schematic longitudinal cross-sectional view of the semiconductor package 4000 shown in FIG. 20.

Referring to FIGS. 20 and 21, the semiconductor package 4000 may include a substrate 4010, an interposer 4020 mounted on the substrate 4010, and processing devices 4030 and memory stacks 4040A, 4040B mounted side-by-side on the interposer 4020.

The semiconductor package 4000, according to one example of the present disclosure, may include at least one memory chip and at least one neural processing unit 100.

The substrate 4010 may comprise a printed circuit board (PCB). A plurality of outer bumps 4090 may be disposed on a bottom surface of the substrate 4010, and a plurality of inner bumps 4080 may be disposed on a top surface of the substrate 4010.

Alternatively, the substrate 4010 may be a glass substrate. Although conventional substrates primarily utilized materials such as silicon or organic materials, these substrates may experience reduced reliability due to a high coefficient of thermal expansion, and issues involving dielectric loss in high-speed signal transmission have occurred. In contrast, glass substrates are excellent in thermal stability and electrical properties.

The glass substrate may include silica (SiO₂) and boron oxide (B₂O₃). Physical and electrical properties of the glass substrate may be optimized by controlling the content of these components. Specific properties may be further enhanced through the doping of additional metal oxides. Furthermore, the glass substrate may also include alumina (Al₂O₃). Silica (SiO₂) may be included at a content of 60% to 80%, and may facilitate achieving high heat resistance and mechanical strength while reducing dielectric loss. Boron oxide (B₂O₃) may be included at a content of 10% to 25%, and may lower the coefficient of thermal expansion and improve workability. It may also provide a high dielectric constant and contribute to mechanical strength. Alumina (Al₂O₃) may be included at a content of 0% to 10%, and may enhance chemical durability and improve mechanical strength. It may also increase the dielectric constant. Metal oxides for property adjustment may include titania (TiO₂), strontium oxide (SrO), magnesia (MgO), and calcium oxide (CaO). Titania (TiO₂) may be included at a content of 1% to 5%, and may increase the dielectric constant while maintaining mechanical strength. Strontium oxide (SrO) may be included at a content of 1% to 5%, and may improve highfrequency signal properties and facilitate low dielectric loss. Magnesia (MgO) may be included at a content of 0% to 5%, and may reduce dielectric loss and increase heat resistance. Calcium oxide (CaO) may be included at a content of 0% to 3%, and may reduce dielectric loss and supplement thermal stability.

For example, the plurality of outer bumps 4090 may be electrically connected to an external system board, main board, or module board. The plurality of outer bumps 4090 may include solder balls or metallic bumps. The plurality of inner bumps 4080 may electrically connect the substrate 4010 and the interposer 4020. The plurality of inner bumps 4080 may include solder balls or metallic bumps. The interposer 4020 may have the form of a board on which the processing unit 4030 and the memory stacks 4040A, 4040B are mounted, and may provide electrical connections for the processing unit 4030 and the memory stacks 4040A, 4040B.

However, the present disclosure is not limited to the memory stacks 4040A and 4040B, and may be configured to include only one of the memory stacks 4040A or 4040B.

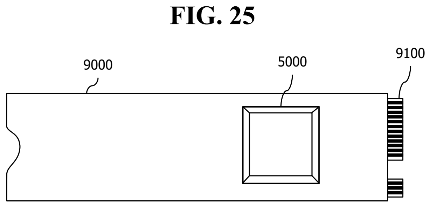

However, the present disclosure is not limited to the outer bumps 4090 of the substrate 4010. For example, referring to FIGS. 25 through 27, the substrate 4010 may be implemented in an M.2 form factor, in which case the outer bumps 4090 may be replaced with an M.2 slot 9100.

The processing device 4030 may include the NPU 100 and one of the CPU 300, GPU 400, and MCU 500.

For example, the processing device 4030 may send clock signals and/or instruction signals to and from the memory stacks 4040A and 4040B, and may receive data signals from and to the memory stacks 4040A and 4040B. Additionally, the processing device 4030 may send electrical signals to and from an external processor, power supply, or input/output device via the interposer 4020 and the substrate 4010. The substrate 4010 may be referred to as a semiconductor package substrate.

The memory stacks 4040A and 4040B may include a first memory stack 4040A disposed on one side of the processing device 4030 and a second memory stack 4040B disposed on the other side. The memory stacks 4040A and 4040B may include, respectively, first and second base dies 4050A and 4050B, and a plurality of memory dies 4051A-4054A and 4051B-4054B stacked on the base dies 4050A and 4050B. In an example, the first and second memory stacks 4040A and 4040B are shown as having four memory dies 4051A-4054A and 4051B-4054B stacked on top of each other.

However, while two memory stacks are described above, this is an example only, and the number of memory stacks is not limited and may be determined according to the computational capabilities of the processing device 4030.

The base dies 4050A and 4050B may include memory cells, test logic circuitry such as design for test (DFT), Joint Test Action Group (JTAG), memory built-in self-test (MBIST), signal interface circuitry such as a PHY, and similar components. At least one of the base dies 4050A or 4050B may be configured to include a plurality of memory cells.

The plurality of memory dies 4051A-4054A and 4051B-4054B may include the memory 200 shown in FIG. 6. The plurality of memory dies 4051A-4054A and 4051B-4054B may be volatile memory (e.g., SRAM, DRAM, or LPDDR). The plurality of memory dies 4051A-4054A and 4051B-4054B may be non-volatile memory (e.g., MRAM (Magnetic RAM) or ReRAM (Resistive RAM)). The memory 200 may comprise at least one or a plurality of memories 200-1 and 200-2.

The type and number of memory dies may be determined according to the processing power of the NPU 100 (e.g., Tera Operations Per Second (TOPS) of the NPU). For example, a memory bandwidth of 2 GB/s to 4 GB/s per 1 TOPS may be required. For example, an NPU with 10 TOPS may have memory configured to provide a memory bandwidth of 20 GB/s to 40 GB/s. The memory bandwidth may be determined according to the operation frequency of the memory and the number of communication channels.

For example, to configure a memory bandwidth of 40 GB/s with LPDDR5, the following formula may be used: Bandwidth (GB/s) = Data rate (Gbps per pin) × Bus width (bits) × Number of channels ÷ 8. Data rate: LPDDR5 typically supports data rates up to 6400 Mbps per pin. Bus width: The bus width of each LPDDR channel is typically 16 bits (2 bytes). However, the number of channels cannot be a decimal and may be an integer.

Each of the plurality of memory dies 4051A-4054A and 4051B-4054B may include through silicon vias (TSVs) 4060A and 4060B. Each of the TSVs 4060A and 4060B may vertically penetrate the plurality of memory dies 4051A-4054A and 4051B-4054B. The TSVs 4060A and 4060B may include central TSVs 4061A and 4061B and non-central TSVs 4062A and 4062B, respectively. The central TSVs 4061A and 4061B may penetrate a central region of the memory stacks 4040A and 4040B. The non-central TSVs 4062A and 4062B may penetrate non-central regions of the memory stacks 4040A and 4040B. For example, the central region may be an area adjacent to an imaginary central vertical line that divides the memory stacks 4040A and 4040B in two, and the non-central region may be an area spaced apart from the imaginary vertical line. The distances from the processing device 4030 to the central TSVs 4061A and 4061B may be greater than the distances from the processing device 4030 to the non-central TSVs 4062A and 4062B, respectively. Alternatively, the electrical paths from the processing device 4030 to the non-central TSVs 4062A and 4062B, respectively, may be smaller than the electrical paths from the processing device 4030 to the central TSVs 4061A and 4061B, respectively. The non-central TSVs 4062A and 4062B may include a first set of non-central TSVs 4062Aa and 4062Ba disposed relatively close to peripheral sides of the memory stacks 4040A and 4040B, and a second set of non-central TSVs 4062Ab and 4062Bb disposed relatively close to a central region (or an imaginary center vertical line) of the memory stacks 4040A and 4040B. Specifically, the first non-central TSVs 4062Aa and 4062Ba may be disposed closest relative to the processing device 4030, the second non-central TSVs 4062Ab and 4062Bb may be disposed next closest to the processing device 4030, and the central TSVs 4061A and 4061B may be disposed farthest relative to the processing device 4030. The distances of the first non-central TSVs 4062Aa and 4062Ba from the processing device 4030 may be smaller than the distances of the second non-central TSVs 4062Ab and 4062Bb from the processing device 4030, respectively. The electrical paths from the processing device 4030 to the central TSVs 4060A and 4061B adjacent to the imaginary center vertical line may be longer than the electrical paths from the processing device 4030 to the TSVs 4062A and 4062B spaced apart from the imaginary vertical line, respectively.

Processor micro-bumps 4035A, 4035B, and 4035C may be disposed between the interposer 4020 and the processing device 4030. The processor micro-bumps may include first processor micro-bumps 4035A for electrically coupling with the first base die 4050A of the first memory stack 4040A, second processor micro-bumps 4035B for electrically coupling with the second base die 4050B of the second memory stack 4040B, and central processor micro-bumps 4035C for electrically coupling with external electronic devices via the interposer 4030 and the substrate 4010. The processor micro-bumps 4035A, 4035B, and 4035C may include solder balls or metallic bumps. The first processor micro-bumps 4035A may be disposed in close proximity to the first memory stack 4040A, and the second processor micro-bumps 4035B may be disposed in close proximity to the second memory stack 4040B.

First memory micro-bumps 4045A and 4046A may be disposed between the interposer 4020 and the first base die 4050A of the first memory stack 4040A, and second memory micro-bumps 4045B and 4046B may be disposed between the interposer 4020 and the second base die 4050B of the second memory stack 4040B. The first memory micro-bumps 4045A and 4046A may include a first outward memory micro-bump 4045A and a first inward memory micro-bump 4046A, and the second memory micro-bumps 4045B and 4046B may include a second outward memory micro-bump 4045B and a second inward memory micro-bump 4046B. The inward and outward may be determined relative to the processing device 4030. The first and second outward memory micro-bumps 4045A and 4045B may be electrically coupled to an external electronic device via the interposer 4020, the inner bumps 4080, the substrate 4010, and the outer bumps 4090. However, as noted above, the outer bumps 4090 may be modified and replaced with sockets, connectors, and similar components. The first inward memory micro-bumps 4046A may be coupled to the first processor micro-bumps 4035A via a first internal connection 4047A inside interposer 4020, and the second memory micro-bumps 4046B may be coupled to the second processor micro-bumps 4035B via a second internal connection 4047B inside the interposer 4020. The first and second inward memory micro-bumps 4046A and 4046B may be disposed closer to the processing device 4030 than the first and second outward memory micro-bumps 4045A and 4045B, respectively. That is, the distances of the first and second outward memory micro-bumps 4045A and 4045B from the processing device 4030 may be greater than the distances of the first and second inward memory micro-bumps 4046A and 4046B from the processing device 4030, respectively.

Between the memory dies 4051A-4054A and 4051B-4054B, and between the TSVs 4060A and 4060B, respectively, inter-die micro-bumps 4049A and 4049B may be disposed. The inter-die micro-bumps 4049A and 4049B may electrically connect the TSVs 4060A and 4060B. The inter-die micro-bumps 4049A and 4049B may comprise solder balls or metallic bumps.

The semiconductor package 4000 according to embodiments of the present disclosure may have relatively short electrical paths through TSVs 4062A and 4062B spaced apart from the imaginary vertical lines, and relatively long electrical paths through TSVs 4061A and 4061B adjacent to the imaginary vertical lines, from the processing device 4030 to the interior of the memory elements 4051A-4054A and 4051B-4054B of the memory stacks 4040A and 4040B.

Furthermore, the technical features of the different examples of the present disclosure may be combined with each other to form variations.

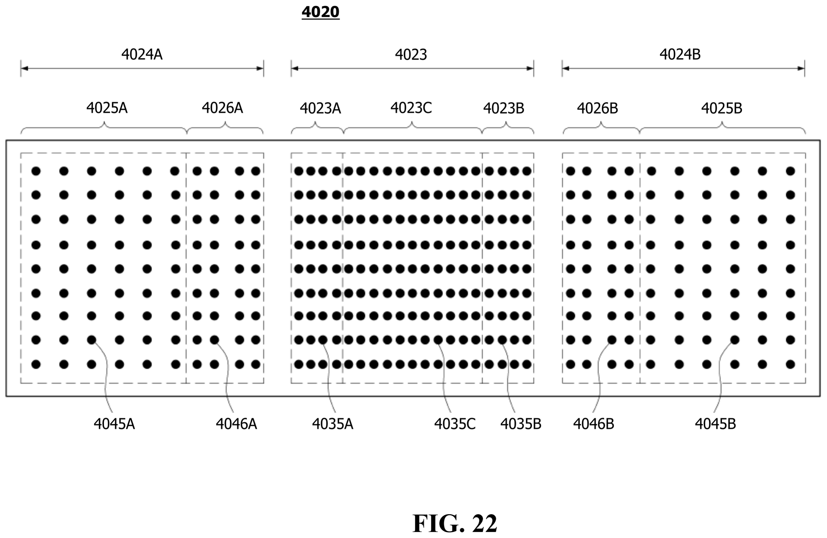

FIG. 22 is a schematic top view illustrating the top surface of the interposer 4020 shown in FIG. 20.

As an example, a ball grid array layout of the interposer 4020 is schematically shown in FIG. 22. Referring to FIG. 22, the interposer 4020 may include a processing device mounting area 4023 and first and second memory stack mounting areas 4024A and 4024B. The first and second memory stack mounting areas 4024A and 4024B may be referred to herein as at least one memory mounting area.

The processing device mounting area 4023 may include a first processing device mounting area 4023A, a second processing device mounting area 4023B, and a central processing device mounting area 4023C. The first and second processing device mounting areas 4023A and 4023B may provide areas on which pads, lands, or connectors may be formed for placement of the first processor micro-bumps 4035A and the second processor micro-bumps 4035B for electrical connection with the first and second memory stacks 4040A and 4040B, respectively. As used herein, "land" refers to a solder pad for making electrical connections, used primarily in semiconductor packages or circuit boards (PCBs). Simply put, it is a metal surface designed for connecting electrical signals or power. The first processing device mounting area 4023A may be disposed in close proximity to the first memory stack mounting area 4024A, and the second processing device mounting area 4023B may be disposed in close proximity to the second memory stack mounting area 4024B. The central processing device mounting area 4023C may provide an area on which pads, lands, or connectors may be formed for disposing the central processor micro-bumps 4035C. The central processing device mounting area 4023C may be disposed in a central area of the processing device mounting area 4023, such as between the first processing device mounting area 4023A and the second processing device mounting area 4023B.

The first and second memory stack mounting regions 4024A and 4024B may include first and second outward memory stack mounting regions 4025A and 4025B, respectively, on which pads, lands, or connectors may be formed for disposing the first and second outward memory micro-bumps 4045A and 4045B. Furthermore, the first and second memory stack mounting areas 4024A and 4024B may include first and second inward memory stack mounting areas 4026A and 4026B, respectively, on which pads, lands, or connectors may be formed for disposing the first and second inward memory micro-bumps 4046A and 4046B. The first and second inward memory stack mounting regions 4026A and 4026B may be disposed in close proximity to the processing device mounting region 4023. That is, the distances from the processing device mounting area 4023 to the first and second outward memory stack mounting areas 4025A and 4025B, respectively, may be greater than the distances from the processing device mounting area 4023 to the first and second inward memory stack mounting areas 4026A and 4026B, respectively. In the illustrated embodiment, the micro-bumps 4035A, 4035B, 4035C, 4045A, 4045B, 4046A, and 4046B may be pads, lands, or connectors.

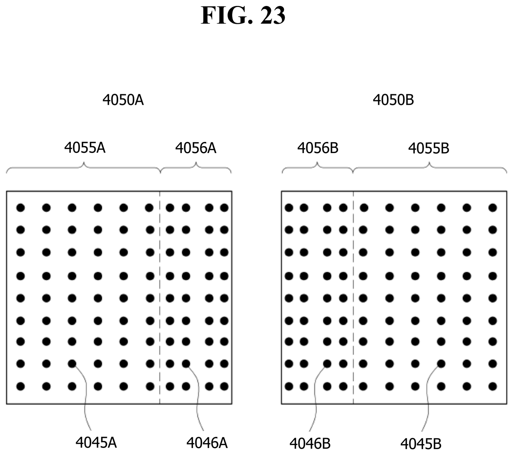

FIG. 23 is a schematic perspective view illustrating first and second base dies 4050A and 4050B of the first and second memory stacks 4040A and 4040B shown in FIG. 20.

As an example, a ball grid array layout of the undersides of the first and second base dies 4050A and 4050B is schematically shown in FIG. 23. Referring to FIG. 23, the undersides of the first and second base dies 4050A and 4050B may include first and second outward memory ball grid arrays 4055A and 4055B, respectively, on which pads, lands, or connectors may be formed for disposing the first and second outward memory micro-bumps 4045A and 4045B. Furthermore, the undersides of the first and second base dies 4050A and 4050B may include first and second inward memory ball grid arrays 4056A and 4056B, respectively, on which pads, lands, or connectors may be formed for the first and second inward memory micro-bumps 4046A and 4046B to be disposed.

The first and second inward memory ball grid arrays 4056A and 4056B may be disposed closer to the processing device 4030 than the first and second outward memory ball grid arrays 4055A and 4055B. As used herein, "inward" refers to a direction closer to the processing device 4030, and "outward" refers to a direction away from the processing device 4030. That is, the distances from the processing device 4030 to the first and second outward memory ball grid arrays 4055A and 4055B, respectively, may be greater than the distances from the processing device 4030 to the first and second inward memory ball grid arrays 4056A and 4056B, respectively.

In the illustrated embodiment, the micro-bumps 4045A, 4045B, 4046A, and 4046B may be pads, lands, or connectors.

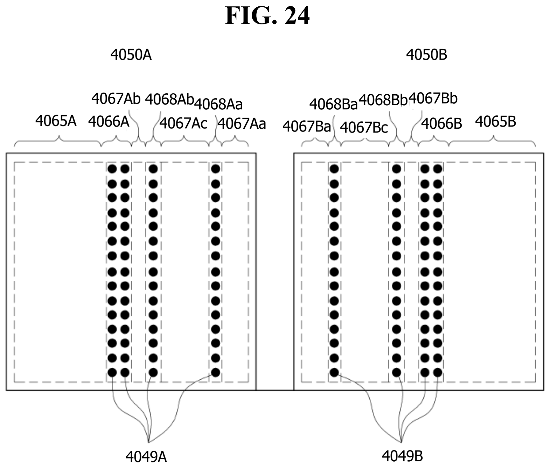

FIG. 24 is a schematic top view illustrating first and second base dies 4050A and 4050B of the first and second memory stacks 4040A and 4040B shown in FIG. 20.

As an example, a ball grid array layout of the top surfaces of the first and second base dies 4050A and 4050B is schematically shown in FIG. 24. Referring to FIG. 24, the top surfaces of the first and second base dies 4050A and 4050B may include circuit occupied regions 4065A and 4065B, central TSV occupied regions 4066A and 4066B, PHY occupied regions 4067Aa-4067Ac and 4067Ba-4067Bc, and non-central TSV occupied regions 4068Aa-4068Ab and 4068Ba-4068Bb, respectively.

The circuit occupied regions 4065A and 4065B may be regions where test logic circuits such as the DFT circuits, the JTAG circuits, and the MBIST circuits may be disposed. Furthermore, the circuit occupied regions 4065A and 4065B may be modified to further include a plurality of memory cells. The circuit occupied regions 4065A and 4065B may be disposed adjacent to outer sides of the first and second base dies 4050A and 4050B furthest away from the processing device 4030.

The central TSV occupied regions 4066A and 4066B may be disposed adjacent to imaginary centerlines that bisect the upper surfaces of the first and second base dies 4050A and 4050B, respectively, in a columnwise direction. More specifically, the central TSV occupied regions 4066A and 4066B may be disposed between the circuit occupied regions 4065A and 4065B and imaginary vertical centerlines bisecting the top surfaces of the first and second base dies 4050A and 4050B, respectively. With further reference to FIG. 21, the central TSV occupied regions 4066A and 4066B may be regions that may be occupied by the central TSVs 4061A and 4061B. That is, the central TSV occupied regions 4066A and 4066B may be vertically overlapping with the central TSVs 4061A and 4061B, respectively. The distances from the processing device 4030 to the circuit occupied regions 4065A and 4065B may be greater than the distances from the processing device 4030 to the central TSV occupied regions 4066A and 4066B, respectively.

With further reference to FIG. 21, the non-central TSV occupied regions 4068Aa-4068Ab and 4068Ba-4068Bb may be regions that may be occupied by the non-central TSVs 4062A and 4062B. That is, the non-central TSV occupied regions 4068Aa-4068Ab and 4068Ba-4068Bb may be vertically overlapping with the non-central TSVs 4062A and 4062B. This will be further explained with reference to FIG. 21. The non-central TSV occupied regions 4068Aa-4068Ab and 4068Ba-4068Bb may overlap with the first non-central TSVs 4062Aa and 4062Ba, forming the first non-central TSV occupied regions 4068Aa and 4068Ba. They may also overlap with the second non-central TSVs 4062Ab and 4062Bb, forming second non-central TSV occupied regions 4068Ab and 4068Bb disposed relatively closer to the imaginary centerlines of the memory stacks 4040A and 4040B.

The PHY occupied regions 4067Aa-4067Ac and 4067Ba-4067Bc may comprise regions disposed between the sides of the base dies 4050A and 4050B and the non-central TSV occupied regions 4068Aa-4068Ab and 4068Ba-4068Bb, and potentially between other occupied regions. The distances from the processing device 4030 to the first non-central TSV occupied regions 4068Aa and 4068Ba, respectively, may be smaller than the distances from the processing device 4030 to the second non-central TSV occupied regions 4068Ab and 4068Bb, respectively. The distances from the processing device 4030 to the second non-central TSV occupied areas 4068Ab and 4068Bb, respectively, may be greater than the distances from the processing device 4030 to the third non-central TSV occupied areas 4068Ac and 4068Bc, respectively. Referring further to FIG. 21, the PHY occupied regions 4067Aa-4067Ac and 4067Ba-4067Bc may be regions that overlap with the inward memory micro-bumps 4046A and 4046B.

Within the central TSV occupied regions 4066A and 4066B, the inter-die micro-bumps 4049A and 4049B may be disposed. The inter-die micro-bumps 4049A and 4049B may electrically connect the central TSVs 4061A and 4061B. Furthermore, the inter-die micro-bumps 4049A and 4049B may electrically connect the non-central TSVs 4062A and 4062B within the non-central TSV occupied regions 4068Aa-4068Ab and 4068Ba-4068Bb. In the illustrated embodiment, the inter-die micro-bumps 4049A and 4049B may be pads, lands, or connectors.

The NPU 100 illustrated in FIG. 3 may be mounted on a small electronic device. For example, the NPU 100 may be mounted on a closed-circuit television (CCTV) camera. To facilitate mounting on a CCTV camera or similar device, a form factor incorporating an M.2 slot 9100 may be utilized.

FIG. 25 illustrates an example of a form factor incorporating an M.2 slot.

The M.2 slot represents a next-generation interface standard for high-speed data transfer, providing high speeds and high efficiency. Due to its compact size, it is being adopted in a variety of electronic devices, including laptops, desktops, and mini-PCs. The compact form factor of M.2 facilitates on-device implementation.

The form factor 9000 shown in FIG. 25 has a width of 22 mm. The length may be 30 mm, 42 mm, 60 mm, 80 mm, or 110 mm, but may be customizable based on the physical constraints of the device to be mounted. The dimensions of the form factor 9000, having a width of 22 mm and a length that may be selected from 30 mm, 42 mm, 60 mm, 80 mm, or 110 mm, constrain the size of the package 5000 co-mounted with the NPU and memory. Specifically, the maximum dimension of the package 5000 may be less than the width of the form factor 9000 (i.e., 22 mm).

Accordingly, methods for downsizing the package 5000 containing the NPU and memory are described below.

In some examples, the form factor may comprise E1.S. The E1.S interface is a form factor designed as a standardized, high-density solution primarily for data center and enterprise storage systems. E1.S may support a variety of protocols and applications, providing high data transfer rates and efficient space utilization. E1.S modules are typically rectangular, with widths ranging from 31.5 mm to 38.4 mm and lengths ranging from 111.49 mm to 318.75 mm. The E1.S may support a Peripheral Component Interconnect Express (PCIe) interface. The PCIe interface may utilize multiple lanes (e.g., x2, x4, x8) to provide significantly higher data transfer rates.

The package 5000 may be configured to include at least one semiconductor chip utilizing a fan-in semiconductor package method, a fan-out semiconductor package method, a package-on-package (PoP) method, and/or a 2.5D package method.

Furthermore, the technical features of the different examples of the present disclosure may be combined with each other to form variations.

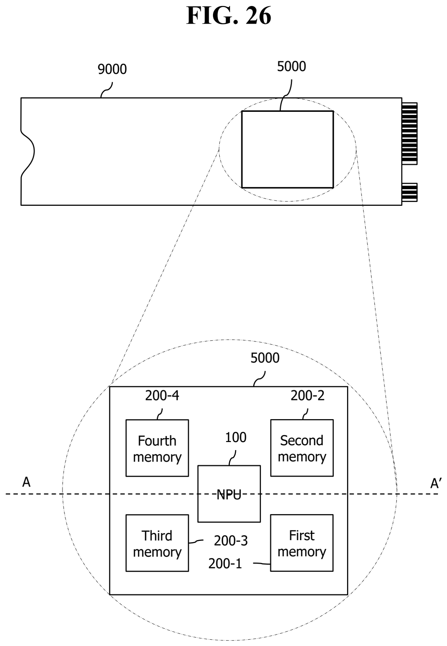

FIG. 26 is an example diagram illustrating a package 5000 according to the first embodiment of the present disclosure.

Referring to FIG. 26, the form factor 9000 with M.2 slots may have a length of 42 mm, 60 mm, 80 mm, or 110 mm.

The package 5000 mounted on the form factor 9000 may include the NPU 100 and a plurality of memories 200-1, 200-2, 200-3, and 200-4.

The NPU 100 may include a plurality of processing elements (PEs) 110, SFUs 150, NPU internal memory 120, an NPU controller 130, and an NPU interface 140, as shown in FIG. 3 or FIG. 5.

The plurality of memories 200-1, 200-2, 200-3, and 200-4 may be Static Random Access Memory (SRAM). Unlike Dynamic Random Access Memory (DRAM), which must refresh its content periodically, the content of SRAM is preserved as long as power is supplied to the memory device. SRAM may enable significantly faster input/output (I/O) compared to DRAM due to its symmetric circuit structure. Furthermore, unlike DRAM, which typically requires two accesses to a memory address in upper bit and lower bit order, SRAM may have the advantage of enabling access in a single operation. Consequently, SRAM may offer higher speed and wider bandwidth than DRAM.

Meanwhile, in SRAM, each bit is stored in two pairs of inverters, which are typically composed of four transistors. The two pairs of inverters maintain stable 0 and 1 values, and two access transistors perform read and write functions. Thus, storing one bit generally requires six transistors.

This results in an increase in the physical size of SRAM while causing a disadvantage of reduced storable data size. In other words, because SRAM has a lower integration density compared to DRAM, it stores fewer bits per unit area. For example, the physical dimensions of the NPU 100 may be 4.50 mm x 4.85 mm. Considering the minimum separation distance required between the NPU 100 and the plurality of memories 200-1, 200-2, 200-3, and 200-4, the physical size of each memory may be limited to 6.43mm x 5.30mm. As stated above, due to SRAM's low integration density, a smaller physical size results in a reduced number of storable bits.

Accordingly, the semiconductor manufacturing process node for SRAM may be lower than that for the NPU. For example, the semiconductor manufacturing process for SRAM may utilize a 14nm node, while the semiconductor manufacturing process for the NPU may utilize a 7nm node. For example, the semiconductor manufacturing process for SRAM may utilize a 5nm node, while the semiconductor manufacturing process for the NPU may utilize a 7nm node. For example, the semiconductor manufacturing process for SRAM may utilize a 2nm node, while the semiconductor manufacturing process for the NPU may utilize a 5nm node.

However, if the performance of the NPU is 10 Tera Operations Per Second (TOPS), and SRAM must provide a memory bandwidth ranging from 20 GB/s to 40 GB/s, then a plurality of SRAMs must be arranged. For this reason, the number of memories, specifically SRAMs, is illustrated as being four in FIG. 26.

Furthermore, if the NPU 100 and the plurality of memories 200-1, 200-2, 200-3, and 200-4 are arranged in close proximity to each other, the size of the package may be 21 mm x 31 mm.

Accordingly, the package 5000 may be mounted on a form factor 9000 having a width of 22 mm and a length of 42 mm.

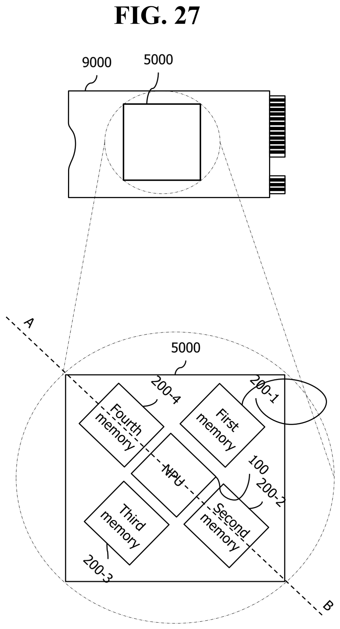

However, the package 5000 shown in FIG. 26 cannot be mounted on a form factor 9000 having a length of 30 mm. Therefore, a method enabling the package 5000 comprising the NPU 100 and the plurality of memories 200-1, 200-2, 200-3, and 200-4 to be mounted on a form factor 9000 having a length of 30 mm will be described hereinafter with reference to FIG. 27.

The package 5000 may be configured to include at least one semiconductor chip utilizing a fan-in semiconductor package method, a fan-out semiconductor package method, a package-on-package (PoP) method, and/or a 2.5D package method.

Furthermore, the technical features of the different examples of the present disclosure may be combined with each other to form variations.

FIG. 27 is an example diagram illustrating a package 5000 according to the second embodiment of the present disclosure.

The NPU 100 shown in FIG. 27 may include a plurality of processing elements (PEs) 110, SFUs 150, NPU internal memory 120, an NPU controller 130, and an NPU interface 140, as shown in FIG. 3 or FIG. 5.

The plurality of memories 200-1, 200-2, 200-3, and 200-4 may be SRAM memories.

Different semiconductor process technologies may be applied to the NPU 100 and the SRAM. For example, the NPU 100 may be manufactured utilizing a 5nm semiconductor process technology, while the SRAM may be manufactured utilizing a 2nm semiconductor process technology. That is, the SRAM and the NPU 100 may be manufactured using different semiconductor manufacturing processes, respectively.

The width of the form factor 9000 shown in FIG. 27 is 22 mm, and the length is 30 mm. In order to mount package 5000 within such a constrained size, the placement of the NPU 100 and the plurality of memories 200-1, 200-2, 200-3, and 200-4 within package 5000 must be improved.

In order to mount the package 5000 within such a constrained size, the placement of the NPU 100 and the memories 200-1, 200-2, 200-3, and 200-4 within the package 5000 may be optimized. The physical dimensions of the NPU 100 may be 4.50 mm x 4.85 mm, and the physical dimensions of each memory may be 6.43 mm x 5.30 mm.

As illustrated with reference to FIG. 27, the NPU 100 and the memories 200-1, 200-2, 200-3, and 200-4 may be disposed diagonally and parallel to the edges of the package 5000. This arrangement may reduce the size of the package 5000 to 21 mm x 21 mm.

Referring to FIG. 27, the configuration of the plurality of semiconductor chips disposed inside the package 5000 may be referred to as a "rotated multi-chip layout". A package 5000 with a rotated multi-chip layout may reduce the overall size of the package 5000 due to the arrangement of each semiconductor chip rotated at a specific angle.

The type and number of memory dies may be determined according to the processing power of the NPU 100 (e.g., Tera Operations Per Second (TOPS) of the NPU). For example, if the performance of the NPU is 10 Tera Operations Per Second (TOPS), and SRAM must provide a memory bandwidth ranging from 20 GB/s to 40 GB/s, then a plurality of SRAMs must be arranged. For this reason, the number of memories, specifically SRAMs, is illustrated as being four in FIG. 27.

Here, the number of memory chips may be determined by considering the processing power (e.g., TOPS) of the neural processing unit 100, the size of a particular form factor, and the size allocatable within a package of a size smaller than the particular form factor.

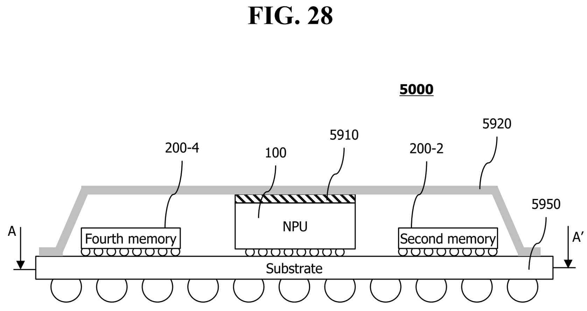

FIG. 28 is an example cross-sectional view illustrating the package 5000 shown in FIG. 26 or FIG. 27 according to lines A-A'.

Referring to FIG. 28, the substrate 5950 may be mounted with the NPU 100 and a plurality of memories (only memories 200-2 and 200-4 are shown in FIG. 28).

The substrate 5950 may function as an interposer, such that the package 5000 may be in the form of a fan-out semiconductor package. Solder bumps may be formed on the lower surface of the substrate 5950. The substrate 5950 may be referred to as a semiconductor package substrate. Alternatively, the substrate 5950 may be a glass substrate.

The glass substrate may include silica (SiO₂) and boron oxide (B₂O₃). Physical and electrical properties may be optimized through controlling the content of silica (SiO₂) and boron oxide (B₂O₃), and specific properties may be enhanced through additional metal oxide doping. Furthermore, the glass substrate may include alumina (Al₂O₃).

An outer sealing layer 5920 may be covered on top of the package 5000 to protect the NPU 100 and the plurality of memories. The outer sealing layer 5920 may comprise a material having good thermal conductivity, which may improve the heat dissipation properties of the package 5000.

Between the outer sealing layer 5920 and the NPU 100, a heat-conducting film 5910 may be attached. The heat conduction film 5910 may include an insulating material having good thermal conductivity.

The plurality of memories may be Static Random Access Memory (SRAM). Unlike Dynamic Random Access Memory (DRAM), which must refresh its content periodically, the content of SRAM is preserved as long as power is supplied to the memory device. SRAM may enable significantly faster input/output (I/O) compared to DRAM due to its symmetric circuit structure. Furthermore, unlike DRAM, which typically requires two accesses to a memory address in upper bit and lower bit order, SRAM may have the advantage of enabling access in a single operation. Consequently, SRAM may offer higher speed and wider bandwidth than DRAM.

Meanwhile, in SRAM, each bit is stored in two pairs of inverters, which are typically composed of four transistors. The two pairs of inverters maintain stable 0 and 1 values, and two access transistors perform read and write functions. Thus, storing one bit generally requires six transistors.

This results in an increase in the physical size of SRAM while causing a disadvantage of reduced storable data size. In other words, because SRAM has a lower integration density compared to DRAM, it stores fewer bits per unit area.

The physical dimensions of the NPU 100 may be 4.50 mm x 4.85 mm, and the physical dimensions of each memory may be 6.43 mm x 5.30 mm. Considering the minimum separation distance required between the NPU 100 and the plurality of memories 200-1, 200-2, 200-3, and 200-4, the physical size of each memory may be limited to 6.43 mm x 5.30 mm. As stated above, due to SRAM's low integration density, a smaller physical size results in a reduced number of storable bits.

For example, if the performance of the NPU is 10 Tera Operations Per Second (TOPS), and SRAM must provide a memory bandwidth ranging from 20 GB/s to 40 GB/s, then a plurality of SRAMs must be arranged.

### <Summary of examples>

A semiconductor package may be configured to achieve a target processing performance within a predetermined volume constraint, the semiconductor package comprising: a processor chip manufactured using a first semiconductor process technology; and at least one memory chip electrically coupled to the processor chip, the at least one memory chip comprising SRAM and manufactured using a second semiconductor process technology distinct from the first semiconductor process technology. The first and second semiconductor process technologies may be selected based on optimizing respective performance, cost, and area characteristics for the processor chip and the at least one SRAM chip, and the overall dimensions of the semiconductor package are configured to fit within the predetermined volume constraint.

A semiconductor package may comprise a plurality of semiconductor chips disposed within the package; and a package body defining an outer boundary of the semiconductor package; wherein the plurality of semiconductor chips are arranged in a layout rotated at a specific angle relative to at least one edge of the package body, such that the overall dimensions of the package body are optimized to fit within a predetermined form factor having a constrained size.

At least one of the semiconductor chips may comprise a stack of a plurality of dies.

The plurality of semiconductor chips includes a logic chip and at least one SRAM chip.

A semiconductor package may be configured to include a plurality of semiconductor chips disposed within a package body that defines the outer boundary of the package. The plurality of semiconductor chips may be arranged in a layout rotated at a specific angle relative to at least one edge of the package body. This rotated arrangement of the semiconductor chips may optimize the overall dimensions of the package body to fit within a predetermined form factor having a constrained size.

In certain embodiments, the plurality of semiconductor chips may include at least one logic chip and at least one SRAM chip. The logic chip may comprise a neural processing unit (NPU). The logic chip and the at least one SRAM chip may be heterogeneous semiconductor chips. The logic chip and the SRAM chip are manufactured using different semiconductor process technologies. The semiconductor process technology for the SRAM chip may correspond to a lower integration density than the semiconductor process technology for the logic chip.

The plurality of semiconductor chips may be arranged side-by-side within the package. In such configurations, the semiconductor chips may be arranged on a substrate or an interposer. At least one of the semiconductor chips may comprise a stack of a plurality of dies. Where an interposer is utilized, the interposer may be disposed on a substrate, and the plurality of semiconductor chips may be disposed on the interposer. The substrate may comprise a printed circuit board (PCB). The interposer may comprise silicon and may include through-silicon vias (TSVs). Where a semiconductor chip comprises a stack of a plurality of dies, at least one of the stacked dies may include TSVs.

The semiconductor package may further comprise a sealing layer that molds the plurality of semiconductor chips. The sealing layer may comprise a polymeric material or an Epoxy Molding Compound (EMC). A rewiring structure may be disposed on the sealing layer and may be electrically coupled to the plurality of semiconductor chips. The rewiring structure may include a multilayer rewiring pattern and an insulation pattern having openings that expose portions of the rewiring pattern.

External connection terminals may be disposed on the package body and may be electrically coupled to the plurality of semiconductor chips via a rewiring structure. The external connection terminals may comprise solder balls, bumps, copper pillar bumps, or may be formed by copper-to-copper direct bonding.

An adhesive layer may be provided to secure at least one of the semiconductor chips within the package body. The adhesive layer may comprise a material having high thermal conductivity.

The semiconductor package may further comprise an electromagnetic shielding layer covering at least a portion of the package body. An outer sealing layer may cover the electromagnetic shielding layer. The outer sealing layer may comprise a material having good thermal conductivity. The package may also include a bottom conductive layer and a thermal conductive film disposed on an external surface of the package body.

In embodiments including a logic chip such as an NPU and a SRAM chip, the SRAM chip may be configured to provide a SRAM bandwidth based on the processing power of the NPU. The relative placement of the NPU and SRAM chip within the rotated layout may be configured to optimize thermal dissipation.

The arrangement of the plurality of semiconductor chips in the rotated layout may also be configured to mitigate warpage effects, enhancing the reliability of the semiconductor package.

A system may comprise the semiconductor package and a form factor having a constrained size, wherein the semiconductor package is dimensioned to fit within the form factor. The form factor may be an M.2 form factor or an E1.S form factor.

A semiconductor package may comprise a substrate, at least one neural processing unit (NPU) chip mounted on the substrate, and at least one SRAM chip mounted adjacent to the NPU chip on the substrate. The NPU chip may be disposed at a rotated orientation relative to a side or a reference axis of the substrate. The at least one SRAM chip may also be disposed at another rotated orientation relative to a side or a reference axis of the substrate. The orientations of the NPU chip and the SRAM chip may be configured such that the overall dimensions of the substrate conform to a predetermined form factor that is smaller than a standard non-rotated layout would require.

The NPU chip and the SRAM chip may be manufactured using different semiconductor manufacturing processes.

In certain embodiments, the rotated orientations of the NPU chip and the at least one SRAM chip may be equal. Alternatively, the rotated orientations may be different. The rotated orientations may correspond to diagonal alignments relative to a rectangular geometry of the substrate.

The substrate may have dimensions configured to fit within a compact form factor, such as a dimension of 21 mm × 31 mm or less. The at least one SRAM chip may comprise two to four SRAM chips. The plurality of SRAM chips may be disposed in multiple directions relative to the NPU chip. For example, the NPU chip may be positioned near the center of the substrate, and the plurality of SRAM chips may be disposed at the periphery of the substrate.

The semiconductor package may be configured to be mounted on a host system conforming to an M.2, E1.S, or other small form factor interface standard. Where the host system conforms to an M.2 form factor, the form factor may include a width of approximately 22 mm and a length ranging from approximately 30 mm to 110 mm. Where the host system conforms to an E1.S form factor, the form factor may include a width ranging from 31.5 mm to 38.4 mm and a length ranging from 111.49 mm to 318.75 mm.

The NPU chip may comprise a system-on-chip architecture including at least one of: an image signal processor (ISP), a central processing unit (CPU), a microcontroller unit (MCU), a graphics processing unit (GPU), or an application processor (AP).

The package may further comprise one or more additional components, including an electromagnetic interference shielding layer, a mechanical sealing layer, a thermally conductive layer, and a ground or power plane layer.

As an AI semiconductor package, the package may comprise an AI processor chip configured to perform neural network operations, and at least one SRAM chip electrically coupled to the AI processor chip. The AI processor chip and the at least one SRAM chip may be disposed in a rotated multi-chip layout configured to reduce the total package footprint relative to a conventional non-rotated layout.

The AI processor chip and/or the at least one SRAM chip may be implemented using one or more of: a flip-chip package, a wafer-level chip-scale package (WLCSP), or a through-silicon via (TSV) structure. The SRAM chip(s) may be provided using a package-on-package configuration.

During package design, the rotation angle of the chips in the layout may be variable and dynamically selectable to optimize routing density and thermal performance. The rotated layout may also optimize the length of interconnects between the NPU chip and the SRAM chip(s). Furthermore, the package may include heat-dissipation components located adjacent to or integrated with the NPU chip or the at least one SRAM chip in the rotated layout.

According to one example of the present disclosure, an NPU semiconductor package is provided. The NPU semiconductor package may include a semiconductor package substrate; an NPU chip rotated, relative to a plane, at a first angle with a first side of the semiconductor package substrate, and mounted on the semiconductor package substrate; and one or more SRAM chips rotated, relative to a plane, at a second angle with a first side of the semiconductor package substrate, and mounted on the semiconductor package substrate adjacent to the NPU chip. The first and second angles may be determined such that a size of the semiconductor package substrate is less than a size of a particular form factor.

The first angle and the second angle may be equal to each other. The first angle and the second angle may be different from each other. The first angle and the second angle may correspond to diagonals of the semiconductor package substrate. The semiconductor package substrate may have a size of 21 mm x 31 mm or less. The plurality of SRAM chips may include two to four SRAM chips. The plurality of SRAM chips may comprise: A first SRAM chip disposed in a first direction of the NPU; a second SRAM chip disposed in a second direction of the NPU; a third SRAM chip disposed in a third direction of the NPU; and a fourth SRAM chip disposed in a fourth direction of the NPU.

The NPU semiconductor package may be mounted in an M.2 form factor. The M.2 form factor may have a width of 22 mm and a length of 30 mm to 110 mm. The NPU semiconductor package may be mounted in an E1.S form factor. The E1.S form factor may have a width of 31.5 mm to 38.4 mm and a length of 111.49 mm to 318.75 mm.

According to one example of the present disclosure, an NPU semiconductor package is also provided. The NPU semiconductor package may include a substrate; an NPU rotated, relative to a plane, at a first angle to a first side of the substrate, and mounted on the substrate; and one or more SRAMs rotated, relative to a plane, at a second angle to a second side of the substrate, and mounted on the substrate adjacent to the NPU. The first and second angles may be adjustable such that the size of the substrate is less than the size of a particular form factor.

The NPU may include a plurality of processing elements (PEs), NPU internal SRAM, an NPU controller, and an NPU interface. The NPU may be disposed in the center of the substrate, and the plurality of SRAMs may be disposed on the periphery of the substrate.

The NPU may be a system-on-a-chip, wherein the system-on-a-chip may further comprise at least one of an image signal processor (ISP), a central processor unit (CPU), a micro processor unit (MPU), a graphics processing unit (GPU), or an application processor (AP) electrically coupled to the NPU core.

The NPU semiconductor package may include at least one of an electromagnetic wave shielding layer, an outer sealing layer, a lower conductive layer, and a heat conduction film.

According to one example of the present disclosure, an AI processor package is provided. The AI processor package may include an AI processor specialized for performing AI computations; and one or more SRAMs electrically coupled to the AI processor. The AI processor and the one or more SRAMs may be arranged in a rotated multi-chip substrate layout to form a rotated multi-chip substrate package.

The rotated multi-chip substrate layout may result in a smaller size of the AI processor package than a non-rotated multi-chip substrate layout.

The AI processor or the one or more SRAMs may be implemented in one of a flip chip package, a Wafer Level Chip Scale Package (WLCSP) package, or a Through Silicon Via (TSV) package. The one or more SRAMs may be implemented as a semiconductor package-on-package.

According to another example of the present disclosure, a neural processing unit (NPU) semiconductor package is provided. The NPU semiconductor package may include a semiconductor package substrate having a solder bump formed on a lower surface thereof; an NPU mounted on the semiconductor package substrate, in a diagonal direction of the semiconductor package substrate; and a plurality of SRAMs mounted on the semiconductor package substrate to surround the NPU in the diagonal direction.

The size of the semiconductor package substrate may be 21 mm x 31 mm or 21 mm x 21 mm. The plurality of SRAMs may comprise four SRAMs. The plurality of SRAMs may comprise: A first SRAM disposed diagonally aligned with the semiconductor package substrate in an upward direction of the NPU; a second SRAM disposed diagonally aligned with the semiconductor package substrate in a leftward direction of the NPU; a third SRAM disposed diagonally aligned with the semiconductor package substrate in a rightward direction of the NPU; and a fourth SRAM disposed diagonally aligned with the semiconductor package substrate in a downward direction of the NPU.

The NPU semiconductor package may be mounted in an M.2 form factor. The M.2 form factor may have a width of 22 mm and a length of one of 30 mm, 42 mm, 60 mm, 80 mm, and 110 mm.

A heat-conducting film may be attached to the upper surface of the NPU.

The top surface of the package may be covered with an outer sealing layer 5920 to protect the NPU and the plurality of SRAMs.

The semiconductor package substrate may include an interposer substrate.

The following numbered examples pertain to embodiments of the present disclosure:
Example 1: A semiconductor package comprising: a substrate; at least one neural processing unit (NPU) chip mounted on the substrate and disposed in a first rotated orientation relative to a side or reference axis of the substrate; and at least one static random-access memory (SRAM) chip mounted adjacent to the at least one NPU chip on the substrate and disposed in a second rotated orientation, wherein the first rotated orientation of the at least one NPU chip and the second rotated orientation of the at least one SRAM chip are configured in a rotated layout such that overall dimensions of the substrate conform to a predetermined form factor smaller than a form factor of a standard non-rotated layout.
Example 2: The semiconductor package of Example 1, wherein the first rotated orientation of the at least one NPU chip and the second rotated orientation of the at least one SRAM chip are equal.
Example 3: The semiconductor package of Example 1, wherein the first rotated orientation of the at least one NPU chip and the second rotated orientation of the at least one SRAM chip are different.
Example 4: The semiconductor package of Example 1, wherein the first rotated orientation and the second rotated orientation correspond to diagonal alignments relative to a rectangular geometry of the substrate.
Example 5: The semiconductor package of any of Examples 1 to 4, wherein the substrate has a dimension of 21 mm × 31 mm or less.
Example 6: The semiconductor package of any of Examples 1 to 5, wherein the at least one SRAM chip comprises two to four SRAM chips.
Example 7: The semiconductor package of any of Examples 1 to 5, wherein the at least one SRAM chip comprises a plurality of SRAM chips and wherein the plurality of SRAM chips are disposed in multiple directions relative to the at least one NPU chip.
Example 8: The semiconductor package of any of Examples 1 to 7, wherein the semiconductor package is configured to be mounted on a host system conforming to an M.2, E1.S, or another small form factor interface standard.
Example 9: The semiconductor package of Example 8, wherein a form factor of the M.2 includes a width of approximately 22 mm and a length ranging from approximately 30 mm to 110 mm.
Example 10: The semiconductor package of Example 8 or 9, wherein a form factor of the E1.S includes a width ranging from 31.5 mm to 38.4 mm, and a length ranging from 111.49 mm to 318.75 mm.
Example 11: The semiconductor package of Example 7 or any of Examples 8 to 10 referring, directly or indirectly, back to Example 7, wherein the at least one NPU chip is positioned near a center of the substrate, and the plurality of SRAM chips are disposed at a periphery of the substrate.
Example 12: The semiconductor package of any of Examples 1 to 11, wherein the at least one NPU chip comprises a system-on-chip architecture including an image signal processor (ISP), a central processing unit (CPU), a microcontroller unit (MCU), a graphics processing unit (GPU), or an application processor (AP).
Example 13: The semiconductor package of any of Examples 1 to 12, further comprising an electromagnetic interference shielding layer, a mechanical sealing layer, a thermally conductive layer, or a ground or power plane layer.
Example 14: The semiconductor package of any of Examples 1 to 13, wherein: the at least one NPU chip comprises an AI processor chip configured to perform neural network operations; the at least one SRAM chip is electrically coupled to the AI processor chip, and the AI processor chip and the at least one SRAM chip are disposed in a rotated multi-chip layout to reduce a total package footprint.
Example 15: The semiconductor package of Example 14, wherein the rotated multi-chip layout reduces a package size relative to a conventional non-rotated layout.
Example 16: An AI semiconductor package comprising: an AI processor chip configured to perform neural network operations; and at least one SRAM chip electrically coupled to the AI processor chip, wherein the AI processor chip and the at least one SRAM chip are disposed in a rotated multi-chip layout to reduce a total package footprint.
Example 17: The AI semiconductor package of Example 16, wherein the rotated multi-chip layout reduces a package size relative to a conventional non-rotated layout.

## Claims

1. A semiconductor package (5000) comprising:
a substrate (5950);
at least one neural processing unit, NPU, chip (100) mounted on the substrate (5950) and disposed in a first rotated orientation relative to a side or reference axis of the substrate (5950); and
at least one static random-access memory, SRAM, chip (200-1, 200-2, 200-3, 200-4) mounted adjacent to the at least one NPU chip (100) on the substrate (5950) and disposed in a second rotated orientation,
wherein the first rotated orientation of the at least one NPU chip (100) and the second rotated orientation of the at least one SRAM chip (200-1, 200-2, 200-3, 200-4) are configured in a rotated layout such that overall dimensions of the substrate (5950) conform to a predetermined form factor smaller than a form factor of a standard non-rotated layout.

2. The semiconductor package (5000) of claim 1,
wherein the first rotated orientation of the at least one NPU chip (100) and the second rotated orientation of the at least one SRAM chip (200-1, 200-2, 200-3, 200-4) are equal.

3. The semiconductor package (5000) of claim 1,
wherein the first rotated orientation of the at least one NPU chip (100) and the second rotated orientation of the at least one SRAM chip (200-1, 200-2, 200-3, 200-4) are different.

4. The semiconductor package (5000) of claim 1,
wherein the first rotated orientation and the second rotated orientation correspond to diagonal alignments relative to a rectangular geometry of the substrate (5950).

5. The semiconductor package (5000) of any of claims 1 to 4,
wherein the substrate (5950) has a dimension of 21 mm × 31 mm or less.

6. The semiconductor package (5000) of any of claims 1 to 5,
wherein the at least one SRAM chip (200-1, 200-2, 200-3, 200-4) comprises two to four SRAM chips (200-1, 200-2, 200-3, 200-4).

7. The semiconductor package (5000) of any of claims 1 to 5,
wherein the at least one SRAM chip (200-1, 200-2, 200-3, 200-4) comprises a plurality of SRAM chips (200-1, 200-2, 200-3, 200-4) and wherein the plurality of SRAM chips (200-1, 200-2, 200-3, 200-4) are disposed in multiple directions relative to the at least one NPU chip (100).

8. The semiconductor package (5000) of any of claims 1 to 7,
wherein the semiconductor package is configured to be mounted on a host system conforming to an M.2, E1.S, or another small form factor interface standard.

9. The semiconductor package (5000) of claim 8,
wherein a form factor of the M.2 includes a width of approximately 22 mm and a length ranging from approximately 30 mm to 110 mm.

10. The semiconductor package (5000) of claim 8 or 9,
wherein a form factor of the E1.S includes a width ranging from 31.5 mm to 38.4 mm, and a length ranging from 111.49 mm to 318.75 mm.

11. The semiconductor package (5000) of claim 7 or any of claims 8 to 10 referring, directly or indirectly, back to claim 7,
wherein the at least one NPU chip (100) is positioned near a center of the substrate (5950), and the plurality of SRAM chips (200-1, 200-2, 200-3, 200-4) are disposed at a periphery of the substrate (5950).

12. The semiconductor package (5000) of any of claims 1 to 11,
wherein the at least one NPU chip (100) comprises a system-on-chip architecture including an image signal processor, a central processing unit, a microcontroller unit, a graphics processing unit, or an application processor.

13. The semiconductor package (5000) of any of claims 1 to 12,
further comprising an electromagnetic interference shielding layer (3350), a mechanical sealing layer, a thermally conductive layer, or a ground or power plane layer.

14. The semiconductor package (5000) of any of claims 1 to 13, wherein:
the at least one NPU chip (100) comprises an AI processor chip configured to perform neural network operations;
the at least one SRAM chip (200-1, 200-2, 200-3, 200-4) is electrically coupled to the AI processor chip, and
the AI processor chip and the at least one SRAM chip (200-1, 200-2, 200-3, 200-4) are disposed in a rotated multi-chip layout to reduce a total package footprint.

15. The semiconductor package (5000) of claim 14,
wherein the rotated multi-chip layout reduces a package size relative to a conventional non-rotated layout.
